(19) **Europäisches Patentamt / European Patent Office / Office européen des brevets**

(11) **EP 3 208 831 B1**

(12) **EUROPEAN PATENT SPECIFICATION**

(45) Date of publication and mention
of the grant of the patent:
**07.07.2021 Bulletin 2021/27**

(21) Application number: **15850113.0**

(22) Date of filing: **06.10.2015**

(51) Int Cl.:
*H01L 21/336* (2006.01)　*H01L 27/10* (2006.01)
*H01L 27/115* (2017.01)　*H01L 29/788* (2006.01)
*H01L 29/792* (2006.01)　*H01L 27/11531* (2017.01)
*H01L 27/11546* (2017.01)　*H01L 21/8234* (2006.01)
*H01L 27/088* (2006.01)

(86) International application number:
**PCT/JP2015/078335**

(87) International publication number:
**WO 2016/060013 (21.04.2016 Gazette 2016/16)**

(54) **METHOD FOR PRODUCING SEMICONDUCTOR INTEGRATED CIRCUIT DEVICES, AND SEMICONDUCTOR INTEGRATED CIRCUIT DEVICE**

VERFAHREN ZUR HERSTELLUNG VON VORRICHTUNGEN MIT INTEGRIERTEN HALBLEITERSCHALTUNGEN SOWIE VORRICHTUNG MIT INTEGRIERTEN HALBLEITERSCHALTUNGEN

PROCEDE DE PRODUCTION DE DISPOSITIFS A CIRCUITS INTEGRES SEMI-CONDUCTEURS, ET DISPOSITIF A CIRCUITS INTEGRES SEMI-CONDUCTEURS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.10.2014 JP 2014211097**

(43) Date of publication of application:
**23.08.2017 Bulletin 2017/34**

(73) Proprietor: **Floadia Corporation**
**Tokyo 187-0031 (JP)**

(72) Inventors:
- **TANIGUCHI Yasuhiro**
  **Kodaira-shi**
  **Tokyo 187-0031 (JP)**
- **KAWASHIMA Yasuhiko**
  **Kodaira-shi**
  **Tokyo 187-0031 (JP)**
- **KASAI Hideo**
  **Kodaira-shi**
  **Tokyo 187-0031 (JP)**

- **SAKURAI Ryotaro**
  **Kodaira-shi**
  **Tokyo 187-0031 (JP)**
- **SHINAGAWA Yutaka**
  **Kodaira-shi**
  **Tokyo 187-0031 (JP)**
- **OKUYAMA Kosuke**
  **Kodaira-shi**
  **Tokyo 187-0031 (JP)**

(74) Representative: **Bandpay & Greuter**
**30, rue Notre-Dame des Victoires**
**75002 Paris (FR)**

(56) References cited:
**WO-A1-2010/084534　JP-A- 2002 164 449**
**JP-A- 2005 142 354　KR-A- 20100 080 241**
**US-A1- 2010 163 965　US-A1- 2010 163 966**
**US-A1- 2010 165 736**

- **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

Technical Field

The present invention relates to a method for producing a semiconductor integrated circuit device, and a semiconductor integrated circuit device.

Background Art

In a conventional memory cell, a sidewall-shaped select gate electrode is disposed on a sidewall of a memory gate electrode through a sidewall spacer made of an insulating member (for example, refer to Patent Literature 1). In another conventional memory cell, a memory gate electrode is disposed between a sidewall-shaped first select gate electrode and a sidewall-shaped second select gate electrode through a sidewall spacer to allow separate control of the first select gate electrode and the second select gate electrode. In such a memory cell, a charge storage layer is provided to a memory gate structure including the memory gate electrode. Data is programmed by injecting charge into the charge storage layer, and erased by removing charge from the charge storage layer.

In the latter memory cell, when charge is injected into the charge storage layer, a low bit voltage is applied to a channel layer below the memory gate structure through a first select gate structure including the first select gate electrode while a second select gate structure including the second select gate electrode blocks source voltage. In this case, a high memory gate voltage is applied to the memory gate electrode of the memory gate structure, and charge is injected into the charge storage layer by a quantum tunneling effect due to a voltage difference between the bit voltage and the memory gate voltage.

In a semiconductor integrated circuit device in which memory cells each having such a configuration are disposed in a matrix of rows and columns, a memory gate line to which a high memory gate voltage is applied is shared by a plurality of memory cells. Thus, when a high memory gate voltage is applied to the memory gate line to inject charge into the charge storage layer of one memory cell, the high memory gate voltage is applied to the memory gate electrode of each of the remaining memory cells sharing the memory gate line although no charge is supposed to be injected into the charge storage layers of the remaining memory cells.

To avoid this voltage application, in a memory cell in which no charge is to be injected in the charge storage layer, a high bit voltage is applied from a bit line to the channel layer of the memory gate structure through the first select gate structure while the second select gate structure connected to a source line blocks voltage application to the channel layer. Accordingly, a high bit voltage is applied to the channel layer of the memory gate structure in which a high memory gate voltage is applied to the memory gate electrode, leading to a reduced voltage difference between the memory gate electrode and the channel layer. As a result, no quantum tunneling effect occurs and no charge is injected into the charge storage layer.

For a plurality of memory cells disposed in such a matrix of rows and columns, a photolithography technique of fabricating a resist by using a photomask, which is a typical semiconductor production process, is employed to fabricate, for example, a conductive layer by using the resist, and produce the first select gate structure, the second select gate structure, and the memory gate structure.

Patent Literature 1: Japanese Patent Laid-Open No. 2011-129816
US2010/165736 A1 discloses a flash memory device that can include first and second memory gates on a substrate, an oxide layer on sides of and on the substrate outside of the first and second memory gates, a source poly contact between the first and second memory gates, first and second select gates outside the first and second memory gates, a drain region outside the first and second select gates, and a metal contact on the drain region and the source poly contact.

Summary of Invention

Technical Problem

Such a semiconductor integrated circuit device includes, in addition to a plurality of memory cells disposed in a matrix of rows and columns, peripheral circuits such as a central processing unit (CPU), an application-specific integrated circuit (ASIC), a sense amplifier, a column decoder, a row decoder, and an input and output circuit. Thus, production of the memory cells disposed in the matrix requires a semiconductor production process of producing the memory cells in addition to a semiconductor production process of producing the peripheral circuits.

In particular, each memory cell described above has a special configuration in which the first select gate electrode and the second select gate electrode are separately controllable. Accordingly, an extra dedicated photomask process using at least one photomask dedicated to fabrication of only a memory circuit region is needed in addition to a conventional dedicated photomask process of fabricating only a memory circuit region, which leads to increase in production cost.

The present invention has been made under such circumstances and aims at providing a method for producing a semiconductor integrated circuit device, and a semiconductor integrated circuit device. In the method, when a first select gate electrode and a second select gate electrode are formed to be separately controllable, an extra dedicated photomask process of fabricating only a memory circuit region does not need to be performed in addition to a conventional dedicated photomask process of fabricating only a memory circuit region, thereby production cost is reduced accordingly.

Solution to Problem

In order to solve the above-described problems, a method for producing a semiconductor integrated circuit device of the present invention is a method for producing semiconductor integrated circuit device, the semiconductor integrated circuit device including a memory circuit region including a memory cell in which a memory gate structure is disposed through a sidewall spacer between a first select gate structure including a first select gate electrode and a second select gate structure including a second select gate electrode, and a peripheral circuit region including a logic gate structure of a peripheral circuit. The method includes:
a sidewall spacer formation step of forming the memory gate structure in the memory circuit region and then forming the sidewall spacer covering the memory gate structure, the memory gate structure including a lower gate insulating film, a charge storage layer, an upper gate insulating film, and a memory gate electrode stacked in this order; a conductive layer formation step of forming a gate insulating film in the memory circuit region in which the memory gate structure is formed and in the peripheral circuit region, and then forming an N-type or P-type conductive layer on the gate insulating film; an electrode insulating portion formation step of forming, in the peripheral circuit region, an opposite-conductivity layer of a conductivity type opposite to a conductivity type of the conductive layer, and forming, along a part of a sidewall of the memory gate electrode through the sidewall spacer, a select gate electrode insulating portion including at least an intrinsic semiconductor layer or an opposite-conductivity-type electrode insulating layer of the conductivity type opposite to the conductivity type of the conductive layer; and a gate electrode formation step of etching back each of the conductive layer and the opposite-conductivity layer in the peripheral circuit region and the memory circuit region by using a resist patterned by using a photomask, so as to allow the conductive layer and the opposite-conductivity layer to remain on the gate insulating film by using the resist and form a logic gate electrode of the logic gate structure in the peripheral circuit region, and to allow the sidewall-shaped first select gate electrode to remain along one sidewall of the memory gate electrode through the sidewall spacer and to allow the sidewall-shaped second select gate electrode to remain along the sidewall on another side of the memory gate electrode through the sidewall spacer in the memory circuit region. The first select gate electrode and the second select gate electrode are electrically insulated from each other by the select gate electrode insulating portion. The select gate electrode insulating portion is disposed between the first select gate electrode and the second select gate electrode and having a PIN junction structure, an NIN junction structure, a PIP junction structure, an NPN junction structure, or a PNP junction structure.

A semiconductor integrated circuit device of the present invention includes: a memory circuit region including a memory cell in which a memory gate structure is disposed between a first select gate structure and a second select gate structure through a sidewall spacer, the first select gate structure including a first select gate electrode, the second select gate structure including a second select gate electrode; and a peripheral circuit region including a logic gate structure of a peripheral circuit. The logic gate structure has a configuration in which a logic gate electrode is disposed on a gate insulating film, the logic gate electrode being formed of a conductive layer or an opposite-conductivity layer same as a layer of the first select gate electrode and the second select gate electrode. The memory gate structure has a configuration in which a lower gate insulating film, a charge storage layer, an upper gate insulating film, and a memory gate electrode are stacked in this order. The first select gate electrode and the second select gate electrode are sidewall-shaped along the sidewall spacer on a sidewall of the memory gate electrode, and are disposed along one line surrounding the memory gate electrode, and are electrically insulated from each other by a plurality of select gate electrode insulating portions each disposed between the first select gate electrode and the second select gate electrode and having a PIN junction structure, an NIN junction structure, a PIP junction structure, an NPN junction structure, or a PNP junction structure.

Advantageous Effects of Invention

According to the present invention, a first select gate electrode and a second select gate electrode electrically insulated from each other are formed in a memory circuit region by using a photomask process of forming a logic gate electrode in a peripheral circuit region. Thus, even when the first select gate electrode and the second select gate electrode are formed to be separately controllable, an extra dedicated photomask process of fabricating only a memory circuit region does not need to be performed in addition to a conventional dedicated photomask process of fabricating only a memory circuit region. Thereby production cost is reduced accordingly.

Brief Description of Drawings

FIG. 1 is a schematic view illustrating a planar layout of a semiconductor integrated circuit device produced by a production method of the present invention.

FIG. 2 is a cross-sectional view illustrating a cross section taken along line A-A' in FIG. 1.

FIG. 3 is a cross-sectional view illustrating a cross section taken along line B-B' in FIG. 1.

FIG. 4 is a cross-sectional view illustrating a cross section taken along line C-C' in FIG. 1.

FIG. 5A is a schematic view illustrating production step (1) for a semiconductor integrated circuit device; FIG. 5B is a schematic view illustrating production step (2) for a semiconductor integrated circuit device; and FIG. 5C is a schematic view illustrating production step (3) for a semiconductor integrated circuit device.

FIG. 6A is a schematic view illustrating production step (4) for a semiconductor integrated circuit device; FIG. 6B is a schematic view illustrating production step (5) for a semiconductor integrated circuit device; and FIG. 6C is a schematic view illustrating production step (6) for a semiconductor integrated circuit device.

FIG. 7A is a schematic view illustrating production step (7) for a semiconductor integrated circuit device; FIG. 7B is a schematic view illustrating production step (8) for a semiconductor integrated circuit device; and FIG. 7C is a schematic view illustrating production step (9) for a semiconductor integrated circuit device.

FIG. 8A is a schematic view illustrating production step (10) for a semiconductor integrated circuit device; and FIG. 8B is a schematic view illustrating production step (11) for a semiconductor integrated circuit device.

FIG. 9 is a schematic view illustrating a planar layout of a state in which a resist is placed over the planar layout of the completed semiconductor integrated circuit device illustrated in FIG. 1, the resist being used to form a first select gate structure, a second select gate structure, a contact formation conductive layer, and a select gate electrode insulating portion in addition to a logic gate electrode.

FIG. 10A is a cross-sectional view illustrating a cross section taken along line A-A' in FIG. 9; and FIG. 10B is a cross-sectional view illustrating a cross section taken along line C-C' in FIG. 9.

Description of Embodiments

Hereinafter, embodiments of the present invention will be described in the following order.

1. Configuration of semiconductor integrated circuit device produced by production method of the present invention
1-1. Planar layout of semiconductor integrated circuit device
1-2. Cross-sections of sites of semiconductor integrated circuit device
1-3. Principles of operation to inject charge into charge storage layer in selected memory cell
1-4. Principles of operation not to inject charge into charge storage layer in nonselected memory cell in which high charge storage gate voltage is applied to memory gate electrode
2. Method for producing semiconductor integrated circuit device
3. Operations and effects
4. Production methods according to other embodiments without third photomask processing step
5. Other embodiments

(1) Configuration of semiconductor integrated circuit device produced by production method of the present invention

(1-1) Planar layout of semiconductor integrated circuit device

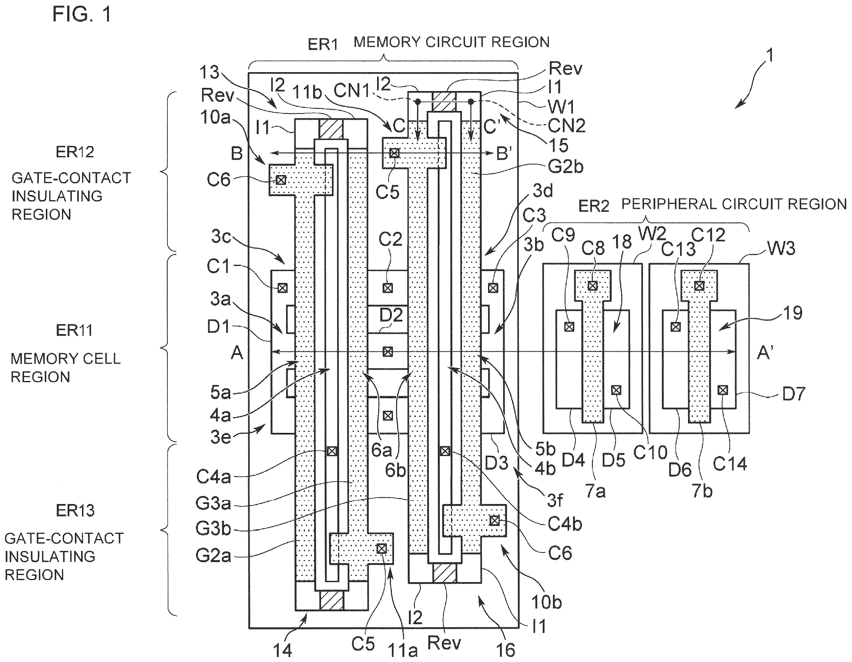

FIG. 1 is a schematic view illustrating a planar layout of a completed semiconductor integrated circuit device 1 produced by a production method of the present invention. FIG. 1 mainly illustrates a planar layout of memory gate structures 4a and 4b, first select gate structures 5a and 5b, and second select gate structures 6a and 6b, which are disposed in a memory circuit region ER1, a planar layout of logic gate structures 7a and 7b disposed in a peripheral circuit region ER2.

FIG. 1 omits illustrations of, for example, a sidewall spacer disposed on each sidewall of the memory gate structures 4a and 4b, any sidewall structure formed in the first select gate structures 5a and 5b and the second select gate structures 6a and 6b, and any element isolation layer disposed in a memory well W1 and logic wells W1 and W2, which will be described later.

The semiconductor integrated circuit device 1 includes the memory circuit region ER1 and the peripheral circuit region ER2 on a semiconductor substrate (not illustrated). For example, the P-type memory well W1 is disposed in the memory circuit region ER1, whereas the P-type logic well W2 and the N-type logic well W3 are disposed in the peripheral circuit region ER2.

The memory circuit region ER1 includes a memory cell region ER11 between gate-contact insulating regions ER12 and ER13. The memory cell region ER11 includes a plurality of memory cells 3a, 3b, 3c, 3d, 3e, and 3f disposed in a matrix of rows and columns. The memory cells 3a, 3b, 3c, 3d, 3e, and 3f all have identical configurations, and thus the following description will be made mainly on the memory cells 3a and 3b disposed in a region along line A-A'.

The memory cell 3a has a configuration in which the memory gate structure 4a is disposed between the first select gate structure 5a and the second select gate structure 6a through a sidewall spacer (not illustrated). In the present embodiment, the memory gate structure 4a, which is included in the memory cells 3a, 3c, and 3e of the first column, and the memory gate structure 4b, which is included in the memory cells 3b, 3d, and 3f of the second column, are formed linearly and disposed next to each other. A contact C4a (C4b) is vertically provided on the memory gate structure 4a (4b) and connected to a memory gate line (not illustrated) to allow application of a memory gate voltage from the memory gate line through the contact C4a (C4b).

In the memory cell region ER11, the first select gate structure 5a (5b) and the second select gate structure 6a (6b) are formed linearly and disposed next to the memory gate structure 4a (4b) including a memory gate electrode G1a (G1b). The first select gate structure 5a (5b) includes a first select gate electrode G2a (G2b). The second select gate structure 6a (6b) includes a second select gate electrode G3a (G3b). The first select gate electrode G2a (G2b) and the second select gate electrode G3a (G3b) each have a sidewall shape along a sidewall spacer on a sidewall of the memory gate electrode G1a (G1b). The first select gate electrode G2a (G2b) and the second select gate electrode G3a (G3b) are disposed along one line (perimeter) surrounding the memory gate electrode G1a (G1b). The first select gate electrode G2a (G2b) and the second select gate electrode G3a (G3b) are electrically insulated from each other by a plurality of select gate electrode insulating portions 13 and 14 (15 and 16), each of which is a PIN junction structure formed between the first select gate electrode G2a (G2b) and the second select gate electrode G3a (G3b).

Two source regions D1 and D3 are symmetrically disposed at a predetermined interval therebetween on a surface (substrate surface) of the memory well W1 in the memory cell region ER11, and a plurality of drain regions D2 are disposed between the source regions D1 and D3. In the memory cell region ER11, the memory cells 3a, 3c, and 3e of the first column are disposed between the source region D1 and the drain region D2. The memory cells 3a, 3c, and 3e each have a configuration in which the memory gate structure 4a is disposed between the first select gate structure 5a and the second select gate structure 6a. The memory cells 3b, 3d, and 3f of the second column are disposed between the drain region D2 and the source region D3. The memory cells 3b, 3d, and 3f each have a configuration in which the memory gate structure 4b is disposed between the second select gate structure 6b and the first select gate structure 5b. The memory cells 3a, 3c, and 3e are symmetrical to the memory cells 3b, 3d, and 3f.

The source region D1 on the surface of the memory well W1 is disposed along the first select gate structure 5a and extends to regions adjacent to the first select gate structure 5a in accordance with the positions of the memory cells 3a, 3c, and 3e of the first column. The source region D1 is shared by the memory cells 3a, 3c, and 3e arranged in one column. A contact C1 is connected to a source line (not illustrated) and vertically provided on the source region D1 to allow application of a source voltage from the source line through the contact C1.

The drain regions D2 on the surface of the memory well W1 between the second select gate structures 6a and 6b are disposed in regions adjacent to the second select gate structures 6a and 6b, and each drain region D2 is disposed in accordance with the positions of the adjacent memory cells 3a and 3b (3c and 3d, or 3e and 3f). The drain region D2 is shared by the adjacent memory cells 3a and 3b (3c and 3d, or 3e and 3f). A contact C2 is connected to a bit line (not illustrated) and vertically provided on the drain region D2 to allow application of a bit voltage through the contact C2 from the bit line. In FIG. 1, the bit line (not illustrated) is shared by the memory cells 3a and 3b (3c and 3d, or 3e and 3f) arranged in a row direction to allow application of an identical bit voltage to the memory cells 3a and 3b (3c and 3d, or 3e and 3f) on a row-by-row basis.

The source region D3 on the surface of the memory well W1 is symmetrical to the source region D1, and similar to the source region D1, extends to regions adjacent to the first select gate structure 5b. The source region D3 is shared by the memory cells 3b, 3d, and 3f of the second column. A contact C3 is vertically provided on the source region D3 and connected to the same source line for the source region D1. Accordingly, an identical source voltage is applied through the contacts C1 and C3 to the memory cells 3a, 3b, 3c, 3d, 3e, and 3f disposed in the memory cell region ER11.

The two memory gate electrodes G1a and G1b, which are next to each other in the memory cell region ER11, extend linearly and next to each other in the gate-contact insulating region ER12 and the gate-contact insulating region ER13 adjacent to the memory cell region ER11. The memory gate electrodes G1a and G1b each have one end disposed in the gate-contact insulating region ER12 and the other end disposed in the gate-contact insulating region ER13.

In the present embodiment, the first select gate electrode G2a, the memory gate electrode G1a, and the second select gate electrode G3a included in the memory cells 3a, 3c, and 3e of the first column are symmetrical to the second select gate electrode G2b, the memory gate electrode G1b, and the first select gate electrode G3b included in the memory cells 3b, 3d, and 3f of the second column. Thus, the following description of the gate-contact insulating regions ER12 and ER13 will be made with respect to the first select gate electrode G2a, the memory gate electrode G1a, and the second select gate electrode G3a included in the memory cells 3a, 3c, and 3e of the first column.

The gate-contact insulating region ER12 includes a contact formation conductive layer 10a disposed at a predetermined position on the first select gate electrode G2a extending from the memory cell region ER11, and also includes the select gate electrode insulating portion 13 electrically insulating the first select gate electrode G2a and the second select gate electrode G3a from each other.

In the present embodiment, the contact formation conductive layer 10a is disposed at a predetermined position on the first select gate electrode G2a in the gate-contact insulating region ER12. A contact C6 connected to a first select gate line (not illustrated) is vertically provided on the contact formation conductive layer 10a. Upon receiving a first select gate voltage from the first select gate line through the contact C6, the contact formation conductive layer 10a allows application of the first select gate voltage only to the first select gate electrode G2a.

The select gate electrode insulating portion 13 disposed in the gate-contact insulating region ER12 includes a pair of intrinsic semiconductor layers I1 and I2, and an opposite-conductivity-type electrode insulating layer Rev disposed between the intrinsic semiconductor layers I1 and I2. The intrinsic semiconductor layer I1 is continuous with the first select gate structure 5a, whereas the intrinsic semiconductor layer I2 is continuous with the second select gate structure 6a.

The opposite-conductivity-type electrode insulating layer Rev provided to the select gate electrode insulating portion 13 has a conductivity type opposite to those of the first select gate electrode G2a and the second select gate electrode G3a. In the present embodiment, for example, the first select gate electrode G2a and the second select gate electrode G3a are of an N type, whereas the opposite-conductivity-type electrode insulating layer Rev is of a P type.

Accordingly, the select gate electrode insulating portion 13 includes the first select gate electrode G2a, the intrinsic semiconductor layer I1, the opposite-conductivity-type electrode insulating layer Rev, the intrinsic semiconductor layer I2, and the second select gate electrode G3a, which are disposed in this order along the sidewall of the memory gate electrode G1a. Thus, a PIN junction structure is formed between the first select gate electrode G2a and the second select gate electrode G3a to electrically insulate the first select gate electrode G2a and the second select gate electrode G3a from each other.

The gate-contact insulating region ER13 includes a contact formation conductive layer 11a disposed at a predetermined position on the second select gate electrode G3a extending from the memory cell region ER11, and also includes the select gate electrode insulating portion 14 electrically insulating the first select gate electrode G2a and the second select gate electrode G3a from each other.

In the present embodiment, the contact formation conductive layer 11a is disposed at a predetermined position on the second select gate electrode G3a in the gate-contact insulating region ER13. A contact C5 connected to a second select gate line (not illustrated) is vertically provided on the contact formation conductive layer 11a. Upon receiving a second select gate voltage from the second select gate line through the contact C5, the contact formation conductive layer 11a allows application of the second select gate voltage only to the second select gate electrode G3a.

The gate-contact insulating region ER13 includes the select gate electrode insulating portion 14 having a configuration similar to that of the select gate electrode insulating portion 13 disposed in the gate-contact insulating region ER12. In the gate-contact insulating region ER13, the select gate electrode insulating portion 14 is disposed between the first select gate electrode G2a and the second select gate electrode G3a along the sidewall of the memory gate electrode G1a. Hence, a PIN junction structure is formed between the first select gate electrode G2a and the second select gate electrode G3a such that the select gate electrode insulating portion 14 electrically insulates the first select gate electrode G2a from the second select gate electrode G3a.

Accordingly, in the memory circuit region ER1, the first select gate electrode G2a, which is continuous with the contact formation conductive layer 10a, is electrically insulated from the second select gate electrode G3a, which is continuous with the contact formation conductive layer 11a, by the select gate electrode insulating portions 13 and 14. This electrical insulation allows separate control of the first select gate electrode G2a and the second select gate electrode G3a.

In the gate-contact insulating regions ER12 and ER13, the second select gate electrode G3b, the memory gate electrode G1b, and the first select gate electrode G2b on the second column respectively have the same configurations as those of the first select gate electrode G2a, the memory gate electrode G1a, and the second select gate electrode G3a on the first column described above.

In the present embodiment, the gate-contact insulating region ER12 is different from the gate-contact insulating region ER13 in that the gate-contact insulating region ER12 includes a contact formation conductive layer 11b disposed at a predetermined position on the second select gate electrode G3b, whereas the gate-contact insulating region ER13 includes a contact formation conductive layer 10b disposed at a predetermined position on the first select gate electrode G2b.

Thus, in the configuration including the second select gate electrode G3b, the memory gate electrode G1b, and the first select gate electrode G2b, the first select gate electrode G2b is electrically insulated from the second select gate electrode G3b by the select gate electrode insulating portions 15 and 16 provided between the first select gate electrode G2b, which is continuous with the contact formation conductive layer 10b, and the second select gate electrode G3b, which is continuous with the contact formation conductive layer 11b. This electrical insulation allows separate control of the first select gate electrode G2b and the second select gate electrode G3b.

The following describes the peripheral circuit region ER2 adjacent to the memory circuit region ER1 with the above-described configuration. In the present embodiment, the peripheral circuit region ER2 is disposed at a position adjacent to the memory cell region ER11 of the memory circuit region ER1, but the present invention is not limited this configuration. The peripheral circuit region ER2 may be disposed at various positions such as a position adjacent to the gate-contact insulating region ER12, a position adjacent to the gate-contact insulating region ER13, or a position adjacent to a region between the memory cell region ER11 and the gate-contact insulating region ER12.

A plurality of peripheral circuits 18 and 19 are disposed in the peripheral circuit region ER2. The peripheral circuit 18 includes, for example, an N-type metal-oxide-semiconductor (MOS) transistor structure on the P-type logic well W2. In such a case, the logic well W2 includes a logic gate structure 7a to allow application of a logic gate voltage to the logic gate structure 7a through a contact C8.

On the logic well W2, impurity diffusion regions D4 and D5 are disposed in regions adjacent to the logic gate structure 7a such that the logic gate structure 7a is disposed between the impurity diffusion regions D4 and D5. A contact C9 is vertically provided on the impurity diffusion region D4. A contact C10 is vertically provided on the impurity diffusion region D5.

The peripheral circuit 19 includes, for example, a P-type MOS transistor structure on the N-type logic well W3. In such a case, the logic well W3 includes a logic gate structure 7b to allow application of a logic gate voltage to the logic gate structure 7b through a contact C12.

On the logic well W3, impurity diffusion regions D6 and D7 are disposed in regions adjacent to the logic gate structure 7b such that the logic gate structure 7b is disposed between the impurity diffusion regions D6 and D7. A contact C13 is vertically provided on the impurity diffusion region D6. A contact C14 is vertically provided on the impurity diffusion region D7.

(1-2) Cross-sections of sites of semiconductor integrated circuit device

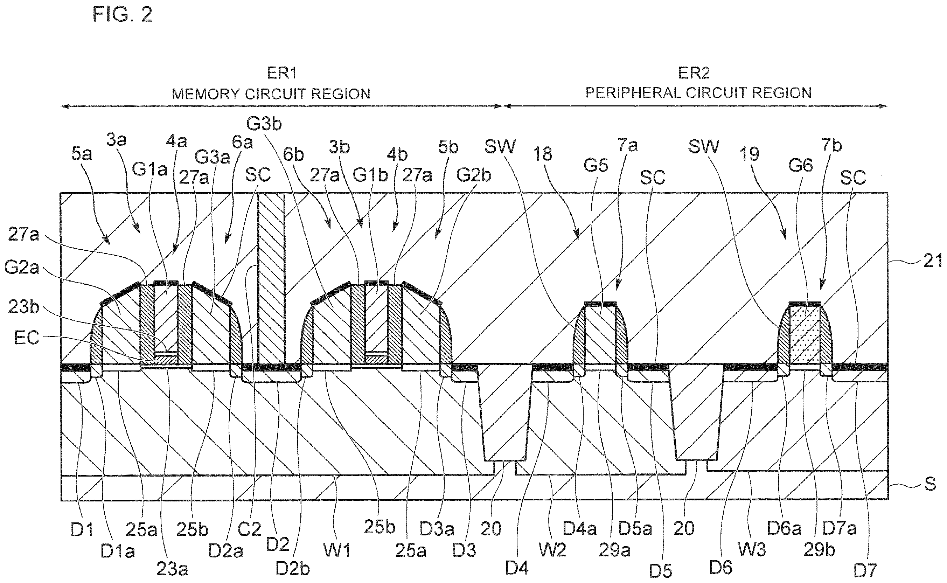

FIG. 2 is a cross-sectional view illustrating cross sections of the memory cells 3a and 3b in the memory cell region ER11 and the peripheral circuits 18 and 19 in the peripheral circuit region ER2, taken along line A-A' in FIG. 1. The semiconductor integrated circuit device 1 includes the semiconductor substrate S. The memory well W1 is disposed on the semiconductor substrate S in the memory circuit region ER1, and the logic wells W2 and W3 are disposed on the semiconductor substrate S in the peripheral circuit region ER2.

In the present embodiment, on the memory well W1, the two memory cells 3a and 3b are disposed in a region including line A-A', and the drain regions D2, on each of which the contact C2 is vertically provided, are disposed on the surface between the memory cells 3a and 3b. Since the memory cells 3a and 3b are symmetrically disposed but have identical configurations, the memory cell 3a will be described below.

On the memory well W1, the memory cell 3a includes, for example, the memory gate structure 4a having an N-type transistor structure, the first select gate structure 5a having an N-type MOS transistor structure, and the second select gate structure 6a having an N-type MOS transistor structure.

The source region D1 and each drain region D2 are spaced at a predetermined distance on the surface of the memory well W1. A source voltage from a source line is applied to the source region D1 through the contact C1 (FIG. 1), and a bit voltage from a bit line is applied to the drain region D2 through the contact C2. In the present embodiment, impurity concentration is $1.0E21/cm^3$ or more in each of the source region D1 and the drain region D2. In the memory well W1, the impurity concentration of a surface region (for example, a region extending to the depth of 50 nm from the surface) in which a channel layer is formed is $1.0E19/cm^3$ or less, preferably is $3.0E18/cm^3$ or less, which is set by impurity implantation performed in a production process.

The memory gate structure 4a includes a charge storage layer EC containing, for example, silicon nitride ($Si_3N_4$), silicon oxynitride (SiON), or alumina ($Al_2O_3$) on the memory well W1 between the source region D1 and the drain region D2 through a lower gate insulating film 23a made of an insulating member such as $SiO_2$. The memory gate structure 4a further includes the memory gate electrode G1a on the charge storage layer EC through an upper gate insulating film 23b made of an insulating member such as $SiO_2$. The lower gate insulating film 23a and the upper gate insulating film 23b of the memory gate structure 4a insulate the charge storage layer EC from the memory well W1 and the memory gate electrode G1a.

A sidewall spacer 27a made of an insulating member is disposed along a sidewall of the memory gate structure 4a. The memory gate structure 4a is adjacent to the first select gate structure 5a through the sidewall spacer 27a. This sidewall spacer 27a, which is disposed between the memory gate structure 4a and the first select gate structure 5a, has the thickness enough to insulate the memory gate structure 4a from the first select gate structure 5a.

The first select gate structure 5a includes a gate insulating film 25a made of an insulating member on the memory well W1 between the sidewall spacer 27a and the source region D1. The gate insulating film 25a has the thickness of less than or equal to 9 nm, preferably less than or equal to 3 nm. The first select gate electrode G2a, to which the first select gate line is connected, is disposed on the gate insulating film 25a.

The sidewall spacer 27a made of an insulating member is disposed along a sidewall on the other side of the memory gate structure 4a. The memory gate structure 4a is adjacent to the second select gate structure 6a through the sidewall spacer 27a. This sidewall spacer 27a, which is disposed between the memory gate structure 4a and the second select gate structure 6a, has the same thickness as that of the sidewall spacer 27a between the memory gate structure 4a and the first select gate structure 5a, and insulates the memory gate structure 4a from the second select gate structure 6a.

The second select gate structure 6a includes a gate insulating film 25b made of an insulating member on the memory well W1 between the sidewall spacer 27a and the drain regions D2. The gate insulating film 25b has the thickness of less than or equal to 9 nm, preferably less than or equal to 3 nm. The second select gate electrode G3a, to which the second select gate line is connected, is disposed on the gate insulating film 25b.

The first select gate electrode G2a and the second select gate electrode G3a, which are disposed along the sidewall of the memory gate electrode G1a through the sidewall spacer 27a, are formed by etching back in a production process to be described later. The first select gate electrode G2a and the second select gate electrode G3a each have a sidewall shape in which the height of the first select gate electrode G2a or the second select gate electrode G3a decreases with the distance from the memory gate electrode G1a such that the top portion of the first select gate electrode G2a or the second select gate electrode G3a is sloped (angled) toward the memory well W1.

A sidewall structure SW made of an insulating member is disposed on each of the sidewall of the first select gate structure 5a and the sidewall of the second select gate structure 6a. An extension region D1a is disposed in a region of a surface of the memory well W1 below one of the sidewall structures SW, and an extension region D2a is disposed in a region of the surface of the memory well W1 below the other sidewall structure SW.

In the present embodiment, when impurity concentration is $1E19/cm^3$ or less in a region extending to the depth of 50 nm from the surface of the memory well W1 between the first select gate electrode G2a and the second select gate electrode G3a, the gate insulating films 25a and 25b are each formed to have the thickness of less than or equal to 9 nm through a subsequent production step. When impurity concentration is $3E18/cm^3$ or less in a region extending to the depth of 50 nm from the surface of the memory well W1 between the first select gate electrode G2a and the second select gate electrode G3a, the gate insulating films 25a and 25b are each formed to have the thickness of less than or equal to 3 nm through a subsequent production step.

The memory cell 3b has a configuration similar to the memory cell 3a. The memory cell 3b includes the memory gate structure 4b on the memory well W1 between the source region D3 and the drain regions D2. The memory gate structure 4b is disposed on the memory well W1 between the first select gate structure 5b and the second select gate structure 6b through the sidewall spacer 27a. In the memory cell 3b, an extension region D3a is disposed in a region of the surface of the memory well W1 below the sidewall structure SW formed on the sidewall of the first select gate structure 5b, whereas an extension region D2b is disposed in a region of the surface of the memory well W1 below the sidewall structure SW formed on the sidewall of the second select gate structure 6b.

The memory well W1 disposed in the memory circuit region ER1 is electrically insulated from the logic well W2 disposed in the peripheral circuit region ER2 by an element isolation layer 20. The logic well W2 disposed in the peripheral circuit region ER2 is electrically insulated from the logic well W3 by another element isolation layer 20. In the present embodiment, the peripheral circuit 18 having an N-type MOS transistor structure is disposed on the logic well W2, whereas the peripheral circuit 19 having a P-type MOS transistor structure is disposed on the logic well W3.

The logic gate structure 7a on the logic well W2 includes a logic gate electrode G5 disposed through a gate insulating film 29a between a pair of the impurity diffusion regions D4 and D5 disposed on the surface. The sidewall structure SW is disposed on a sidewall of the logic gate structure 7a. Extension regions D4a and D5a are respectively disposed in regions of the logic well W2 surface below the sidewall structures SW.

The logic well W3, which has a conductivity type different from that of the logic well W2, has a configuration similar to that of the logic well W2. The logic gate structure 7b on the logic well W3 includes a logic gate electrode G6, disposed through a gate insulating film 29b, between a pair of the impurity diffusion regions D6 and D7 on the surface. The sidewall structure SW is disposed on a sidewall of the logic gate structure 7b. Extension regions D6a and D7a are respectively disposed in regions of the logic well W2 surface below the sidewall structures SW.

In the present embodiment, the logic gate structure 7a on the logic well W2 includes the logic gate electrode G5, into which, for example, N-type impurities are implanted, whereas the logic gate structure 7b on the logic well W3 includes the logic gate electrode G6, into which for example, P-type impurities are implanted. However, the present invention is not limited thereto. The logic gate electrodes G5 and G6 may have the same conductivity type.

An insulating layer 21 covers sites such as the first select gate structures 5a and 5b, the memory gate structures 4a and 4b, the second select gate structures 6a and 6b, the contact C2, the logic gate structures 7a and 7b of the semiconductor integrated circuit device 1 so as to insulate these sites from each other. Silicide SC covers surfaces of other various sites such as the drain regions D1 and D3 and the source region D2.

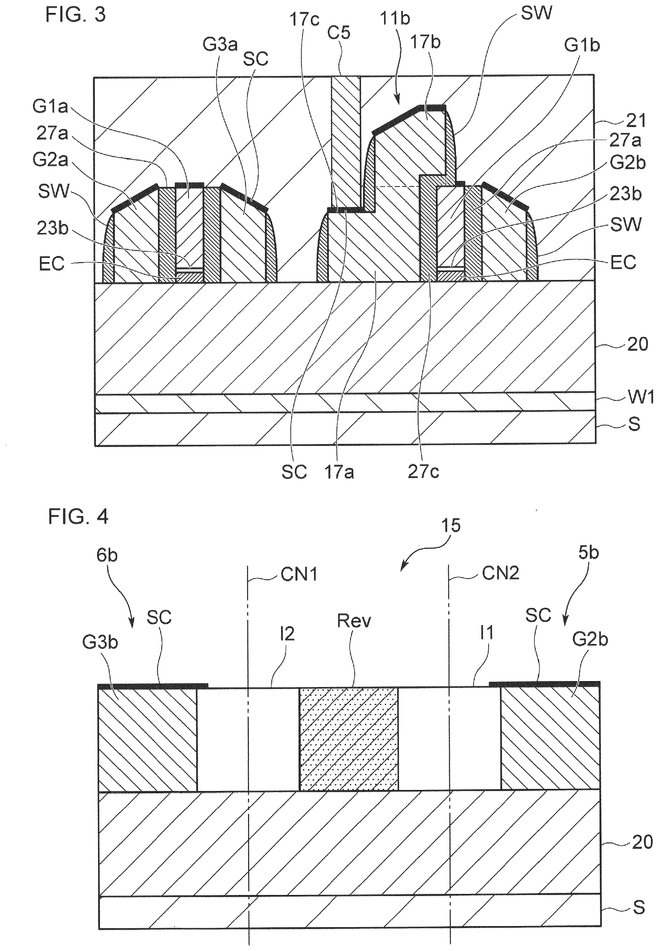

FIG. 3 is a cross-sectional view taken along line B-B' in FIG. 1, illustrating a cross section of the contact formation conductive layer 11b provided to the second select gate electrode G3b in the gate-contact insulating region ER12 of the memory circuit region ER1. As illustrated in FIG. 3, the contact formation conductive layer 11b is disposed on the element isolation layer 20 on the memory well W1.

The contact formation conductive layer 11b mounts across (extends over) one sidewall of the memory gate electrode G1b and a part of a top portion of the memory gate electrode G1b from a surface (substrate surface) of the element isolation layer 20. A contact installation surface 17c is disposed on a base 17a disposed on the element isolation layer 20. The contact installation surface 17c has a flat shape in accordance with the surface shape of the element isolation layer 20. A sidewall spacer 27c is disposed between the contact formation conductive layer 11b and the memory gate electrode G1b to insulate the contact formation conductive layer 11b from the memory gate electrode G1b.

The column-shaped contact C5 is vertically provided on the contact installation surface 17c of the contact formation conductive layer 11b through the silicide SC. The second select gate voltage is applied through the contact C5. Accordingly, the second select gate voltage is applied to the second select gate electrode G2b through the contact formation conductive layer 11b. In the contact formation conductive layer 11b, the sidewall structure SW is disposed on each of a sidewall of the base 17a and a sidewall of a mounting portion 17b. The mounting portion 17b is integral with the base 17a and extends to the top portion of the memory gate electrode G1b.

In the present embodiment, the sidewall-shaped first select gate electrode G2b is disposed on the sidewall on the other side of the memory gate electrode G1b through the sidewall spacer 27a. The contact formation conductive layer 11b faces the first select gate electrode G2b through the sidewall spacers 27a and 27c. As illustrated in FIG. 3, the first select gate electrode G2a faces the second select gate electrode G3a through the memory gate electrode G1a and the sidewall spacer 27a on a side on which the memory gate electrode G1a is disposed.

FIG. 4 is a cross-sectional view taken along line C-C' in FIG. 1, illustrating a cross section of the select gate electrode insulating portion 15 in the gate-contact insulating region ER12 of the memory circuit region ER1. FIG. 4 is a schematic view linearly illustrating a cross section from the second select gate electrode G3b to a corner CN1 of the intrinsic semiconductor layer 12, a cross section from the corner CN1 of the intrinsic semiconductor layer 12 to a corner CN2 of the intrinsic semiconductor layer I1 through the opposite-conductivity-type electrode insulating layer Rev, and a cross section from the corner CN2 of the intrinsic semiconductor layer I1 to the first select gate electrode G2b.

As illustrated in FIG. 4, in a region in which the select gate electrode insulating portion 15 is disposed, the element isolation layer 20 is disposed on the semiconductor substrate S. The intrinsic semiconductor layer I1, the opposite-conductivity-type electrode insulating layer Rev, and the intrinsic semiconductor layer 12 are disposed on the element isolation layer 20. In the select gate electrode insulating portion 15, one end of the intrinsic semiconductor layer I1 is continuous with an end of the first select gate electrode G2b, whereas the other end of the intrinsic semiconductor layer I1 is continuous with one end of the opposite-conductivity-type electrode insulating layer Rev. In the select gate electrode insulating portion 15, one end of the intrinsic semiconductor layer 12 is continuous with an end of the second select gate electrode G3b, whereas the other end of the intrinsic semiconductor layer 12 is continuous with the other end of the opposite-conductivity-type electrode insulating layer Rev.

The opposite-conductivity-type electrode insulating layer Rev of the select gate electrode insulating portion 15 has a conductivity type opposite to those of the first select gate electrode G2b and the second select gate electrode G3b. The PIN junction structure is thus formed by the first select gate electrode G2b, the second select gate electrode G3b, the intrinsic semiconductor layers I1 and 12, and the opposite-conductivity-type electrode insulating layer Rev to electrically insulate the first select gate electrode G2b from the second select gate electrode G3b. The silicide SC is disposed on the surfaces of the first select gate electrode G2b and the second select gate electrode G3b. No silicide is disposed in a region extending from the opposite-conductivity-type electrode insulating layer Rev to the intrinsic semiconductor layer 12 nor in a region extending from the opposite-conductivity-type electrode insulating layer Rev to the intrinsic semiconductor layer I1. This allows the select gate electrode insulating portion 15 to reliably have the PIN junction structure between the first select gate electrode G2b and the second select gate electrode G3b. Thus, the first select gate electrode G2b is electrically insulated from the second select gate electrode G3b.

(1-3) Principles of operation to inject charge into charge storage layer in selected memory cell

The following gives simple description of a case in which data is programmed into the memory cell 3a by injecting charge into, for example, the charge storage layer EC of the memory cell 3a in the semiconductor integrated circuit device 1 produced by the production method of the present invention. In this case, as illustrated in FIG. 2, in the memory cell (may be referred to as a selected memory cell) 3a in which charge is injected into the charge storage layer EC, the charge storage gate voltage of 12 V is applied from the memory gate line (not illustrated) to the memory gate electrode G1a of the memory gate structure 4a through the contact C4a (FIG. 1) so as to form the channel layer (not illustrated) along a region of the surface of the memory well W1 facing the memory gate electrode G1a.

In this case, the gate OFF voltage of 0 V is applied to the first select gate electrode G2a of the first select gate structure 5a from the first select gate line (not illustrated) through the contact C6 (FIG. 1) and the contact formation conductive layer 10a, and the source OFF voltage of 0 V is applied to the source region D1. Accordingly, no channel layer is formed in the surface region of the memory well W1 facing the first select gate electrode G2a. The first select gate structure 5a blocks the electrical connection between the source region D1 and the channel layer below the memory gate structure 4a, and prevents voltage application from the source region D1 to the channel layer below the memory gate structure 4a.

The second select gate voltage of 1.5 V is applied to the second select gate electrode G3a of the second select gate structure 6a from the second select gate line (not illustrated) through the contact C5 (FIG. 1) and the contact formation conductive layer 11a. The charge storage bit voltage of 0 V is applied to the drain region D2. Accordingly, a channel layer is formed in the memory well W1 facing the second select gate electrode G3a of the second select gate structure 6a, and the memory well W1 facing the second select gate electrode G3a becomes a conductive state. Hence, the drain region D2 is electrically connected to the channel layer below the memory gate structure 4a, and the charge storage bit voltage of 0 V is applied to the channel layer below the memory gate structure 4a. In this case, the substrate voltage of 0 V, which is the same as the charge storage bit voltage, is applied to the memory well W1.

Accordingly, since the memory gate electrode G1a has a voltage of 12 V and the channel layer below the memory gate structure 4a has a voltage of 0 V, a large voltage difference of 12 V occurs between the memory gate electrode G1a and the channel layer. This voltage difference causes the quantum tunneling effect, by which charge is injected into the charge storage layer EC to program data.

(1-4) Principles of operation not to inject charge into charge storage layer in nonselected memory cell in which high charge storage gate voltage is applied to memory gate electrode

In the semiconductor integrated circuit device 1 produced by the production method of the present invention, for example, when no charge is to be injected into the charge storage layer EC of the memory cell 3a, a high charge storage gate voltage the same as that for data programming is applied to the memory gate electrode G1a. With this voltage application, the first select gate structure 5a blocks the electrical connection between the source region D1 and the channel layer below the memory gate structure 4a, and the second select gate structure 6a blocks the electrical connection between the drain region D2 and the channel layer below the memory gate structure 4a. Accordingly, charge is prevented from being injected into the charge storage layer EC of the memory gate structure 4a.

In this case, the charge storage gate voltage of 12 V is applied to the memory gate electrode G1a of the memory gate structure 4a in the memory cell (may be referred to as a nonselected memory cell) 3a in which no charge is to be injected into the charge storage layer EC. The charge storage gate voltage is applied (transmitted) to the memory well W1, thereby forming a channel layer along the surface of the memory well W1 facing the memory gate electrode G1a.

The gate OFF voltage of 0 V is applied to the first select gate electrode G3a of the first select gate structure 5a from the first select gate line (not illustrated) through the contact C6 (FIG. 1) and the contact formation conductive layer 10a. The source OFF voltage of 0 V is applied to the source region D1. Accordingly, the memory well W1 facing the first select gate electrode G2a of the memory cell 3a is in a non-conductive state, and thus the first select gate structure 5a blocks the electrical connection between the source region D1 and the channel layer below the memory gate structure 4a.

In addition, the second select gate voltage of 1.5 V is applied to the second select gate electrode G3a of the second select gate structure 6a from the second select gate line (not illustrated) through the contact C5 (FIG. 1) and the contact formation conductive layer 11a. The off voltage of 1.5 V is applied to the drain region D2. Accordingly, the memory well W1 facing the second select gate electrode G3a is in a non-conductive state, and thus the second select gate structure 6a blocks the electrical connection between the drain region D2 and the channel layer below the memory gate structure 4a.

As described above, a region of the memory well W1 below the first select gate structure 5a and a region of the memory well W1 below the second select gate structure 6a become non-conductive states, the first and second select gate structures 5a and 6a being disposed on the respective sides of the memory gate structure 4a of the memory cell 3a. The non-conductive states block the electrical connection between the source region D1 and the channel layer, which faces the memory gate electrode G1a and is formed in the surface region of the memory well W1, and the electrical connection between the drain region D2 and the channel layer. Accordingly, a depletion layer is formed around the channel layer.

A capacitor (hereinafter referred to as a gate-insulator capacitor) C2 is achieved by a three-layer configuration of the upper gate insulating film 23b, the charge storage layer EC, and the lower gate insulating film 23a. A capacitor (hereinafter referred to as a depletion-layer capacitor) C1 of the depletion layer is formed in the memory well W1 and surrounds the channel layer. The capacitors C1 and C2 are connected to each other in series. For example, when the gate-insulator capacitor C2 has a capacitance three times as large as that of the depletion-layer capacitor C1, the channel layer has a channel potential Vch calculated to be 9 V by a formula below.

[Formula 1]

$$Vch = (\text{Memory gate voltage MV} - \text{Substrate voltage CV}) \times \frac{\text{Capacitance of gate-insulator capacitor C2}}{\text{Capacitance of depletion-layer capacitor C1} + \text{Capacitance of gate-insulator capacitor C2}}$$

Thus, in the memory gate structure 4a, the channel potential Vch of the channel layer surrounded by the depletion layer in the memory well W1 is 9 V when the charge storage gate voltage of 12 V is applied to the memory gate electrode G1a. Accordingly, there is a small voltage difference of 3 V between the memory gate electrode G1a and the channel layer. As a result, the quantum tunneling effect does not occur, and thus charge is prevented from being injected into the charge storage layer EC.

In the memory cell 3a, an impurity diffusion region having a high impurity concentration is not formed in a region of the memory well W1 between the memory gate structure 4a and the first select gate structure 5a nor a region of the memory well W1 between the memory gate structure 4a and the second select gate structure 6a. Thus, the depletion layer is reliably formed around the channel layer formed near the surface of the memory well W1. The depletion layer prevents application of the channel potential Vch from the channel layer to the gate insulating films 25a and 25b of the respective first select gate structure 5a and the second select gate structure 6a.

Accordingly, in the memory cell 3a, the depletion layer prevents the channel potential Vch of the channel layer from being applied to the gate insulating films 25a and 25b when the gate insulating films 25a and 25b of the first select gate structure 5a and the second select gate structure 6a have thicknesses reduced in accordance with a low source voltage applied to the source region D1 and a low bit voltage applied to the drain region D2. Thus, the insulation breakdown of the gate insulating films 25a and 25b due to the channel potential Vch is avoided.

(2) Method for producing semiconductor integrated circuit device

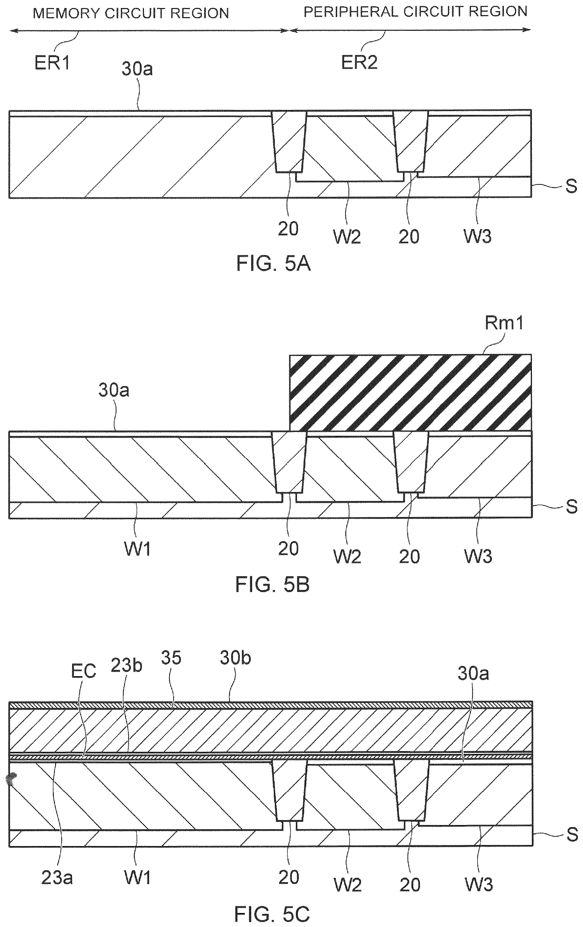

The semiconductor integrated circuit device 1 having the above-described configuration is produced through a production process described below, without an extra dedicated photomask process of fabricating only a memory circuit region in addition to a conventional dedicated photomask process of fabricating only a memory circuit region. FIGS. 5A, 5B, and 5C each illustrate a cross section taken along line A-A' in FIG. 1. In this step, first, as illustrated in FIG. 5A, after the semiconductor substrate S is prepared, the element isolation layer 20 made of an insulating member is formed at predetermined portions such as boundaries of the memory circuit region ER1 and the peripheral circuit region ER2 by, for example, a shallow trench isolation (STI) method.

Subsequently, a sacrificial oxide film 30a is formed on a surface of the semiconductor substrate S by, for example, a thermal oxidation method to perform impurity implantation. Then, the P-type logic well W2 and the N-type logic well W3 are formed by implanting P-type impurities and N-type impurities, respectively, into the peripheral circuit region ER2 by, for example, an ion implantation technique.

Subsequently, a resist is patterned by a photolithography technique and an etching technique using a first photomask (not illustrated) dedicated to fabrication of the memory circuit region ER1. As illustrated in FIG. 5B, in which any corresponding part to that in FIG. 5A is denoted by an identical reference numeral, the memory circuit region ER1 is exposed, and a resist Rm1 covering the peripheral circuit region ER2 is formed.

Subsequently, the memory well W1 is formed by implanting P-type impurities only into the memory circuit region ER1 by using the patterned resist Rm1. In addition, N-type impurities are implanted into the memory circuit region ER1 to form the channel formation layer (not illustrated) on the substrate surface facing the memory gate electrodes G1a and G1b and the sidewall spacer 27a (FIG. 2), which are to be formed later. Then, the resist Rm1 is used to remove the sacrificial oxide film 30a in the memory circuit region ER1 by using, for example, hydrofluoric acid (first photomask processing step).

In the first photomask processing step, in a case in which a P-type substrate is used as the semiconductor substrate S, the step of forming the memory well W1 by implanting P-type impurities into the semiconductor substrate S may be omitted.

Subsequently, after the resist Rm1 is removed, as illustrated in FIG. 5C, in which any corresponding part to that in FIG. 5B is denoted by an identical reference numeral, an ONO film, in which the layer-shaped (sheet-shaped) lower gate insulating film 23a, the layer-shaped charge storage layer EC, and the layer-shaped upper gate insulating film 23b are stacked in this order, is formed on the entire surfaces of the memory circuit region ER1 and the peripheral circuit region ER2. Then, a memory gate electrode conductive layer 35, which is to be formed into the memory gate electrodes G1a and G1b, is formed on the upper gate insulating film 23b. Subsequently, a protection insulating layer 30b made of an insulating member is formed on the memory gate electrode conductive layer 35 by, for example, the thermal oxidation method or a chemical vapor deposition (CVD) method.

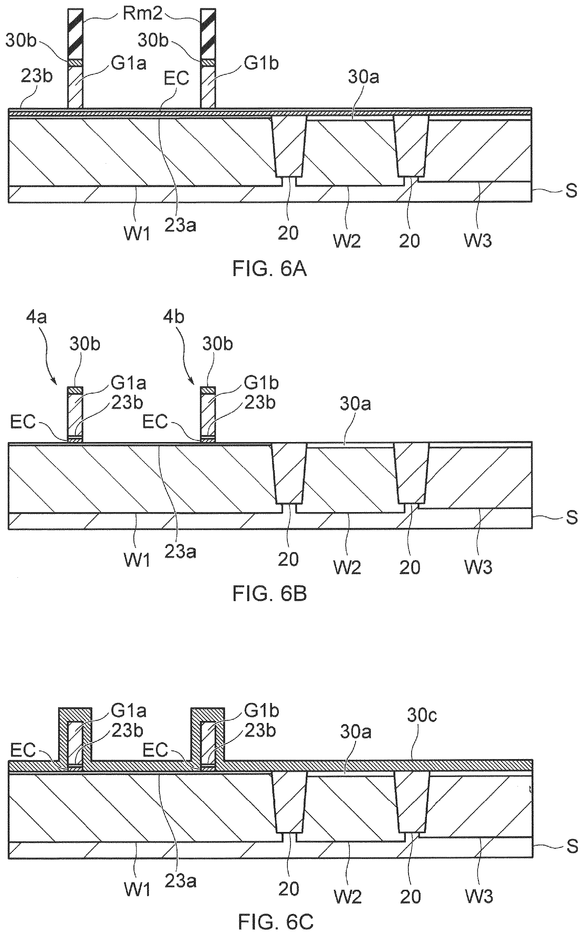

Subsequently, a resist is patterned by the photolithography technique and the etching technique using a second photomask (not illustrated) dedicated to fabrication of the memory circuit region ER1. As illustrated in FIG. 6A, in which any corresponding part to that in FIG. 5C is denoted by an identical reference numeral, a resist Rm2 is formed only where the memory gate structures 4a and 4b are to be formed. Then, the memory gate electrode conductive layer 35 is patterned by using the resist Rm2, and thus, the memory gate electrodes G1a and G1b are formed (second photomask processing step).

Subsequently, after the resist Rm2 is removed, the upper gate insulating film 23b and the charge storage layer EC exposed in regions other than those where the memory gate electrodes G1a and G1b are to be formed are removed (ON film is removed) in this order as illustrated in FIG. 6B, in which any corresponding part to that in FIG. 6A is denoted by an identical reference numeral. Thus, the patterned upper gate insulating film 23b and charge storage layer EC are disposed below the patterned memory gate electrodes G1a and G1b. As a result, the lower gate insulating film 23a, the charge storage layer EC, the upper gate insulating film 23b, and the memory gate electrode G1a (G1b) are stacked in this order to form the memory gate structure 4a (4b) in the memory circuit region ER1 (memory gate structure formation step).

Subsequently, a protection insulating film 30c is formed on the entire surfaces of the memory circuit region ER1 and the peripheral circuit region ER2 as illustrated in FIG. 6C, in which any corresponding part to that in FIG. 6B is denoted by an identical reference numeral. The present embodiment describes a case in which the single-layer protection insulating film 30c is formed on the entire surfaces, but the present invention is not limited to a single-layer film. For example, a two-layer protection insulating film in which an oxidebased insulating film and a nitride-based insulating film are stacked in this order may be formed on the entire surfaces.

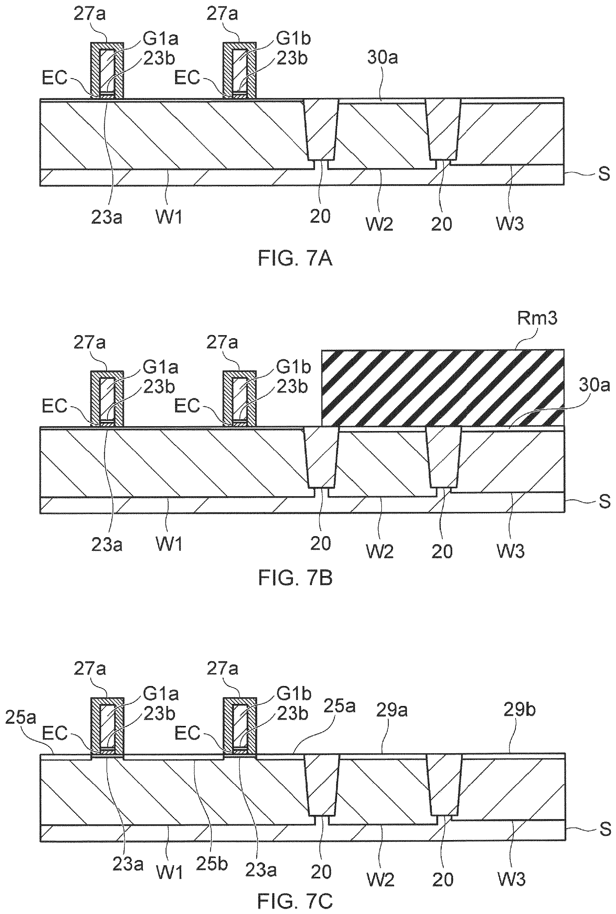

Subsequently, as illustrated in FIG. 7A, in which any corresponding part to that in FIG. 6C is denoted by an identical reference numeral, the protection insulating film 30c is etched back to form the sidewall spacers 27a covering the memory gate structures 4a and 4b (sidewall spacer formation step). Subsequently, a resist is patterned by the photolithography technique and the etching technique using a third photomask (not illustrated) dedicated to fabrication of the memory circuit region ER1. This patterning forms a resist Rm3 covering the entire surface of the peripheral circuit region ER2 but leaving the memory circuit region ER1 exposed, as illustrated in FIG. 7B, in which any corresponding part to that in FIG. 7A is denoted by an identical reference numeral.

Subsequently, impurities are implanted by using the resist Rm3 into the portions of the memory circuit region ER1 where the first select gate structures 5a and 5b (FIG. 2) and the second select gate structures 6a and 6b (FIG. 2) are to be formed. This impurity implantation forms a channel formation layer (not illustrated) in regions of the substrate surface facing the second select gate electrodes G3a and G3b and the first select gate electrode G2a and G2b, which are to be formed later (third photomask processing step).

Subsequently, after the resist Rm3 is removed, the sacrificial oxide film 30a in the peripheral circuit region ER2 is removed by using, for example, hydrofluoric acid. Then, as illustrated in FIG. 7C, in which any corresponding part to that in FIG. 7B is denoted by an identical reference numeral, for example, the thermal oxidation method is employed to form the gate insulating films 25a and 25b on the portions of the memory circuit region ER1 where the first select gate electrodes G2a and G2b (FIG. 1) and the second select gate electrodes G3a and G3b are to be formed and to form the gate insulating films 29a and 29b on the portions of the peripheral circuit region ER2 where the logic gate electrodes G5 and G6 are to be formed.

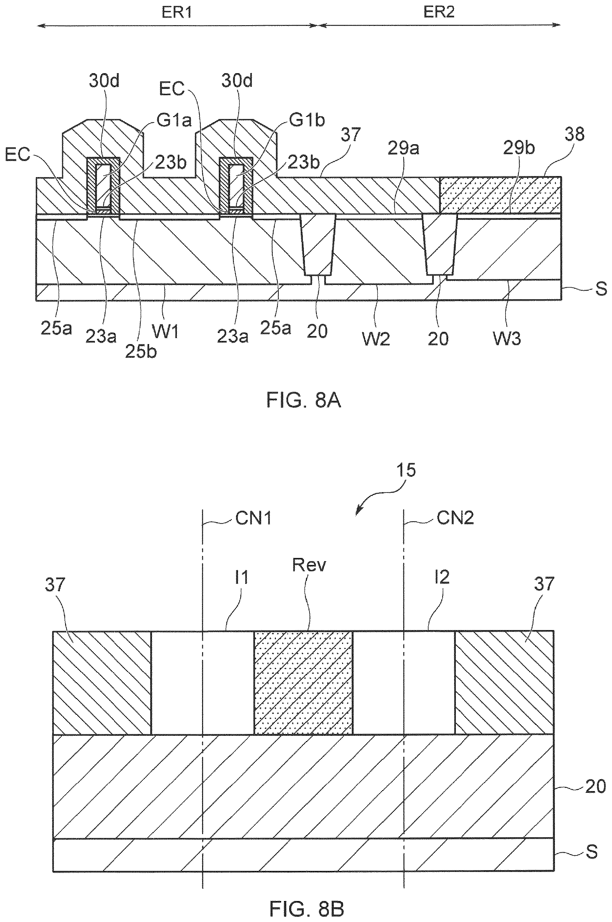

Subsequently, an intrinsic semiconductor fabrication layer made of intrinsic semiconductor such as polysilicon is formed on the entire surfaces of the memory circuit region ER1 and the peripheral circuit region ER2. Then, N-type impurities are implanted into the intrinsic semiconductor fabrication layer in predetermined portions of the memory circuit region ER1 and the peripheral circuit region ER2, to form an N-type conductive layer 37 in a region of the intrinsic semiconductor fabrication layer as illustrated in FIG. 8A, in which any corresponding part to that in FIG. 7C is denoted by an identical reference numeral. At this time, for example, a resist patterned by using a photomask is used to leave the intrinsic semiconductor fabrication layer intact in portions of the peripheral circuit region ER2 where an opposite-conductivity layer 38 is to be formed later and in portions of the memory circuit region ER1 where the select gate electrode insulating portions 13, 14, 15, and 16 are to be formed later.

Subsequently, P-type impurities are implanted by using, for example, a resist, which is patterned by using a photomask, into a portion of the peripheral circuit region ER2 where the opposite-conductivity layer 38 is to be formed and into a portion of the memory circuit region ER1 where the opposite-conductivity-type electrode insulating layer Rev is to be formed. This impurity implantation forms the opposite-conductivity layer 38 in the peripheral circuit region ER2, and the opposite-conductivity-type electrode insulating layer Rev of each of the select gate electrode insulating portions 13, 14, 15, and 16 in the memory circuit region ER1. This process leaves the intrinsic semiconductor fabrication layer intact only in portions where the intrinsic semiconductor layers I1 and I2 of each of the select gate electrode insulating portions 13, 14, 15, and 16 are to be formed. Accordingly, the intrinsic semiconductor layers I1 and I2 are separately formed with the opposite-conductivity-type electrode insulating layer Rev interposed between the intrinsic semiconductor layers I1 and I2 as illustrated in FIG. 8B, which illustrates a cross section taken along line B-B' in FIG. 1.

In this manner, in the production method of the present invention, when the opposite-conductivity layer 38 is formed in the peripheral circuit region ER2, the opposite-conductivity-type electrode insulating layers Rev are formed in portions of the gate-contact insulating regions ER12 and ER13 of the memory circuit region ER1 where the select gate electrode insulating portions 13, 14, 15, and 16 are to be formed. The opposite-conductivity-type electrode insulating layer Rev is formed along a sidewall spacer on the sidewall of the memory gate electrode G1b. Accordingly, the select gate electrode insulating portions 13, 14, 15, and 16 each including a PIN junction structure are formed along the sidewall spacer on the sidewall of the memory gate electrode G1b.

The above-described photomask process performed to implant impurities corresponds to a conventional implantation photomask process of implanting particular impurities in a predetermined portion of the peripheral circuit region ER2. The implantation photomask process is employed to implant particular impurities in a predetermined portion of the memory circuit region ER1. Thus, the above-described photomask process is not a photomask process dedicated to fabrication of the memory circuit region ER1, but is a photomask process of fabricating both of the memory circuit region ER1 and the peripheral circuit region ER2.

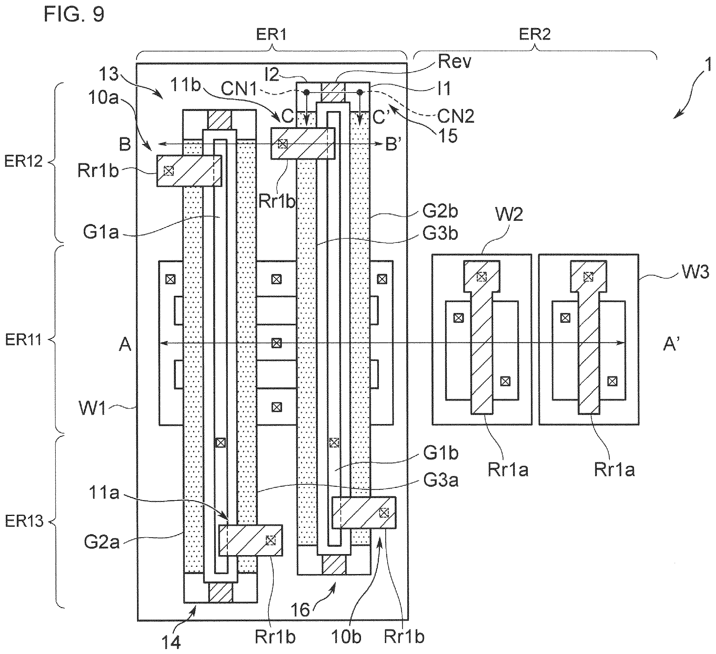

Subsequently, a resist is patterned by the photolithography technique and the etching technique using another photomask (not illustrated). The resist is used to fabricate the conductive layer 37 and the opposite-conductivity layer 38 in the peripheral circuit region ER2, and the conductive layer 37, the intrinsic semiconductor layers I1 and 12, and the opposite-conductivity-type electrode insulating layer Rev in the memory circuit region ER1. FIG. 9 is a schematic view illustrating a state in which resists Rrla and Rrlb patterned by using the photomasks are placed over the planar layout of the completed semiconductor integrated circuit device 1 illustrated in FIG. 1.

As illustrated in FIG. 9, the resist Rrla is formed to cover portions of the peripheral circuit region ER2 where the logic gate electrodes G5 and G6 (FIG. 1) are to be formed. The resist Rrlb is formed to cover only portions of the gate-contact insulating regions ER12 and ER13 of the memory circuit region ER1 where the contact formation conductive layers 10a, 11a, 10b, and 11b are to be formed.

The conductive layer 37, the intrinsic semiconductor layers I1 and 12, and the opposite-conductivity-type electrode insulating layer Rev, which are exposed in the memory circuit region ER1, are etched back and the conductive layer 37 and the opposite-conductivity layer 38 (FIGS. 8A and 8B), which are exposed in the peripheral circuit region ER2, are etched back in the state where the resist Rrla covers the portions of the peripheral circuit region ER2 where the logic gate electrodes G5 and G6 (FIG. 1) are to be formed and the resist Rrlb covers the portions of the gate-contact insulating regions ER12 and ER13 of the memory circuit region ER1 where the contact formation conductive layers 10a, 11a, 10b, and 11b are to be formed, as described above.

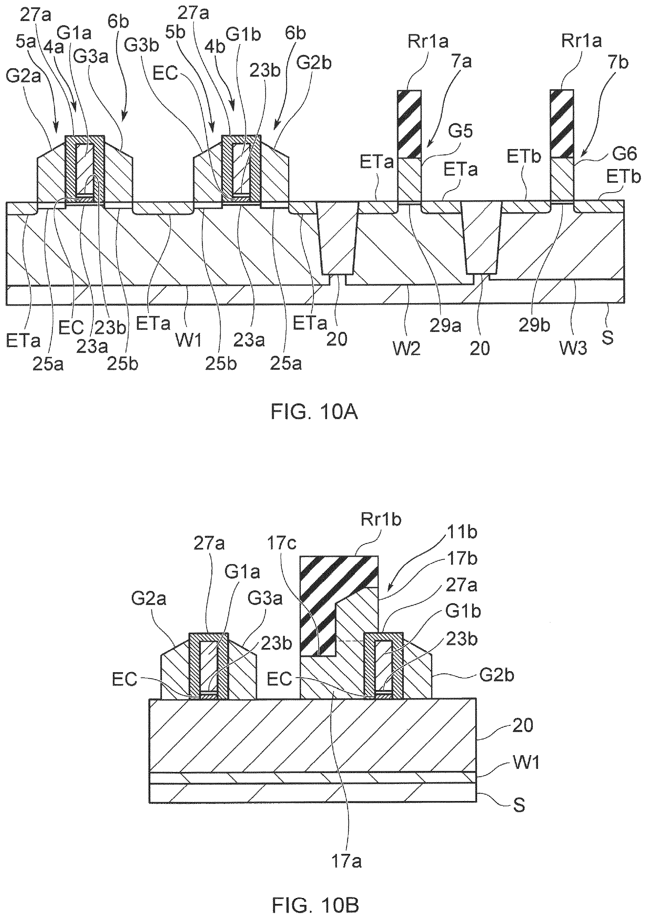

This process removes the conductive layer 37 and the opposite-conductivity layer 38 being externally exposed in the peripheral circuit region ER2 as illustrated in FIG. 10A, in which any corresponding part to that in FIG. 8A is denoted by an identical reference numeral. Accordingly, only the conductive layer 37 and the opposite-conductivity layer 38 being covered by the resist Rrla remain. As a result, in the peripheral circuit region ER2, the logic gate electrodes G5 and G6 are formed in accordance with the outline shape of the resist Rr1a. Thus, the logic gate electrodes G5 and G6 are stacked on the gate insulating films 29a and 29b to form the logic gate structures 7a and 7b, respectively.

At the same time, the conductive layer 37 being exposed in the memory circuit region ER1 is etched back to form the sidewall-shaped first select gate electrodes G2a and G2b and the sidewall-shaped second select gate electrodes G3a and G3b along the sidewall spacers 27a on the sidewalls of the memory gate structures 4a and 4b.

At the same time, the intrinsic semiconductor layers I1 and I2 and the opposite-conductivity-type electrode insulating layer Rev are etched back to form the sidewall-shaped select gate electrode insulating portions 13, 14, 15, and 16 along the sidewall spacers 27a on the sidewalls of the memory gate electrodes G1a and G1b.

At the same time, in the memory circuit region ER1, portions of the conductive layer 37 near the memory gate electrode G1a (G1b) remain intact by using the resist Rrlb (FIG. 9), to form the contact formation conductive layers 10a and 11a (10b and 11b) on the first select gate electrode G2a (G2b) and the second select gate electrode G3a (G3b).

Since the contact formation conductive layers 10a, 11a, 10b, and 11b all have identical configurations, the following description will be made on the contact formation conductive layer 11b disposed in a region including line B-B' in FIG. 9. As illustrated in FIG. 10B, which illustrates a cross section taken along line B-B' in FIG. 9, in the contact formation conductive layer 11b, the base 17a disposed on the element isolation layer 20 is formed integrally with the mounting portion 17b extending to a part of the top portion of the memory gate electrode G1b. The contact installation surface 17c, which has a flat shape in accordance with the surface of the element isolation layer 20, is formed on the base 17a.

In the above-described process, the conductive layer 37 in the memory circuit region ER1 is processed. Thereby, in the memory circuit region ER1, the sidewall-shaped first select gate electrode G2a (G2b) and the sidewall-shaped second select gate electrode G3a (G3b), which are formed along the sidewall spacers 27a on the sidewalls of the memory gate electrodes G1a and G1b, and the contact formation conductive layers 10a, 11a, 10b, and 11b are formed.

Subsequently, after the resists Rrlb and Rrlb are removed by, for example, ashing, a resist patterned for an N type or a P type is used to implant low concentration of N-type impurities or P-type impurities into the memory circuit region ER1 and the peripheral circuit region ER2 by, for example, the ion implantation technique. Accordingly, as illustrated in FIG. 10A (FIG. 10A illustrates the resists Rrla and Rrlb, which are supposed to be removed in this step), an N-type extension region ETa is formed on the substrate surface on the memory well W1 and on the substrate surface on the logic well W2, which are being externally exposed, whereas a P-type extension region ETb is formed on the substrate surface on the logic well W3 being externally exposed.

Lastly, the resist is removed, followed by a step of forming the sidewall structure SW, a step of forming the source regions D1 and D3 and the drain regions D2 by implanting high concentration of N-type impurities or P-type impurities into necessary places by, for example, the ion implantation technique, a step of forming the silicide SC, and a step of forming, for example, the insulating layer 21 and the contacts C1, C2, C3, ....and so forth, which are performed in order. Thus, the semiconductor integrated circuit device 1 having the configuration illustrated in FIGS. 1, 2, 3, and 4 is produced.

(3) Operations and effects

In the above-described method of producing the semiconductor integrated circuit device 1, the gate insulating films 25a, 25b, 25c, 29a, and 29b are formed in the memory circuit region ER1 (FIG. 7A), in which the memory gate structures 4a and 4b covered by the sidewall spacer 27a are formed, and the peripheral circuit region ER2. Then, the conductive layer 37 is formed on the gate insulating films 25a, 25b, 25c, 29a, and 29b (FIG. 8A).

In the method of producing the semiconductor integrated circuit device 1, the opposite-conductivity layer 38 of a conductivity type opposite to that of the conductive layer 37 is formed in the peripheral circuit region ER2. In addition, the select gate electrode insulating portions 13, 14, 15, and 16, in each of which the opposite-conductivity-type electrode insulating layer Rev of a conductivity type opposite to that of the conductive layer 37 is disposed between the separated intrinsic semiconductor layers I1 and 12, are formed along some parts of the sidewalls of the memory gate structures 4a and 4b through the sidewall spacers 27a (FIGS. 8A and 8B).

In the method of producing the semiconductor integrated circuit device 1, the resists Rrla and Rrlb patterned by using the photomasks are used to etch back the conductive layer 37 and the opposite-conductivity layer 38 in the peripheral circuit region ER2, and the conductive layer 37, the intrinsic semiconductor layers I1 and 12, and the opposite-conductivity-type electrode insulating layer Rev in the memory circuit region ER1. Accordingly, in the peripheral circuit region ER2, the conductive layer 37 and the opposite-conductivity layer 38 remain intact on the gate insulating films 29a and 29b by using the resist Rrla, to form the logic gate electrodes G5 and G6.

At the same time, in the memory circuit region ER1, the contact formation conductive layers 10a, 11a, 10b, and 11b, the sidewall-shaped first select gate electrode G2a (G2b), and the sidewall-shaped second select gate electrode G3a (G3b) (FIGS. 10A and 10B) are formed. The contact formation conductive layers 10a, 11a, 10b, and 11b remain by using the resists Rrlb, to cover parts of the memory gate electrodes G1a and G1b through the sidewall spacers 27a. The first select gate electrode G2a (G2b) is continuous with the contact formation conductive layer 10a (10b) and remains along the sidewall of the memory gate structure 4a (4b) through the sidewall spacer 27a. The second select gate electrode G3a (G3b) is continuous with the contact formation conductive layer 11a (11b) and remains along the sidewall on the other side of the memory gate structure 4a (4b) through the sidewall spacer 27a.

The first select gate electrode G2a (G2b) and the second select gate electrode G3a (G3b) are disposed along one line surrounding the memory gate electrode G1a (G1b), and electrically insulated from each other by the select gate electrode insulating portions 13 and 14 (15 and 16) each having a PIN junction structure between the first select gate electrode G2a (G2b) and the second select gate electrode G3a (G3b).

According to the present invention, the first select gate electrode G2a (G2b) and the second select gate electrode G3a (G3b) electrically insulated from each other are formed in the memory circuit region ER1 during a photomask process of forming the logic gate electrodes G5 and G6 in the peripheral circuit region ER2. Thus, the first select gate electrode G2a (G2b) and the second select gate electrode G3a (G3b) are formed to be separately controllable, without an extra dedicated photomask process of fabricating only the memory circuit region ER1 in addition to the conventional dedicated photomask process of fabricating only the memory circuit region. Thereby, production cost is reduced accordingly.

In the method of producing the semiconductor integrated circuit device 1, a photomask process of patterning a resist by using a photomask dedicated to fabrication of only the memory circuit region ER1 includes a total of three steps: (i) a first photomask processing step (FIG. 5B) of forming the channel formation layer by impurity implantation into portions of the substrate surface where the memory gate structures 4a and 4b and the sidewall spacers 27a are to be formed in the memory circuit region ER1, and removing the sacrificial oxide film 30a in the memory circuit region ER1, (ii) a second photomask processing step (FIG. 6A) of forming the memory gate electrodes G1a and G1b by patterning the memory gate electrode conductive layer 35, and (iii) a third photomask processing step (FIG. 7B) of forming the channel formation layer by impurity implantation into portions where the first select gate electrodes G2a and G2b and the second select gate electrodes G3a and G3b are to be formed.

Accordingly, in the method of producing the semiconductor integrated circuit device 1, the memory cells 3a, 3b, 3c, 3d, 3e, and 3f are incorporated through the production process, in which only the steps corresponding to the three photomasks are performed in addition to a typical process for producing the peripheral-circuit. In the memory cells 3a, 3b, 3c, 3d, 3e, and 3f, the first select gate electrode G2a (G2b) and the second select gate electrode G3a (G3b) are formed to sandwich the memory gate electrode G1a (G1b), and are separately controlled. Thereby cost is reduced.

(4) Production methods according to other embodiments without third photomask processing step

In the above-described embodiment, the dedicated photomask process of patterning a resist by using at least one photomask dedicated to fabrication of the memory circuit region ER1 includes a total of three steps: the first photomask processing step, the second photomask processing step, and the third photomask processing step. However, the present invention is not limited thereto. Only a total of two steps, the first photomask processing step and the second photomask processing step may be performed, without the impurity implantation in the third photomask processing step.

In other words, the third photomask processing step does not need to be performed in a case in which the completed first select gate structures 5a and 5b and second select gate structures 6a and 6b each has a desired threshold voltage (Vth) without the impurity implantation in the third photomask processing step. In that case, the third photomask processing step may be omitted.

In such a production method without the third photomask processing step, the sidewall spacers 27a covering the memory gate structures 4a and 4b (FIG. 6B) are formed as illustrated in FIG. 7A (sidewall spacer formation step). Then, the sacrificial oxide film 30a in the peripheral circuit region ER2 is removed by using, for example, hydrofluoric acid. Thereafter, as illustrated in FIG. 7C, for example, the thermal oxidation method is employed to form the gate insulating films 25a and 25b on the portions of the memory circuit region ER1 where the first select gate electrode G2a and G2b (FIG. 1) and the second select gate electrodes G3a and G3b (FIG. 1) are to be formed and to form the gate insulating films 29a and 29b on the portions of the peripheral circuit region ER2 where the logic gate electrodes G5 and G6 (FIG. 1) are to be formed. Then, similar to the production method of the above-described embodiment, the semiconductor integrated circuit device 1 illustrated in FIG. 1 is produced through the production steps illustrated in FIGS. 8 to 10.

In the present embodiment without the third photomask processing step, the memory cells 3a, 3b, 3c, 3d, 3e, and 3f are incorporated by adding a production process corresponding to two photomasks in addition to a typical peripheral-circuit production process. In the memory cells 3a, 3b, 3c, 3d, 3e, and 3f, the first select gate electrodes G2a and G2b and the second select gate electrodes G3a and G3b are formed to sandwich the memory gate electrodes G1a and G1b, and are separately controlled. Thus, the production method without the third photomask processing step uses a reduced number of photomasks as compared to the production method of the above-described embodiment, which leads to cost reduction.

(5) Other embodiments

The present invention is not limited to the present embodiment, but various modifications are possible within the scope of the present invention. For example, the number of the memory cells 3a, 3b, 3c, 3d, 3e, and 3f, the number of the peripheral circuits 18 and 19, the number of the contact formation conductive layers 10a, 11a, 10b, and 11b, and the number of the select gate electrode insulating portions 13, 14, 15, and 16 may be any other numbers. The conductivity types of the conductive layer 37, the opposite-conductivity layer 38, the memory well W1, and the logic wells W2 and W3 may be of any one of the N type or the P type.

In the above-described embodiment, in the electrode insulating portion formation step of forming the select gate electrode insulating portion including at least the intrinsic semiconductor layer or the opposite-conductivity-type electrode insulating layer of the conductivity type opposite to that of the conductive layer along a part of a sidewall of a memory gate structure through a sidewall spacer, the select gate electrode insulating portions 13 and 14 (15 and 16), each including the opposite-conductivity-type electrode insulating layer Rev of a conductivity type opposite to that of the conductive layer 37 between the separated intrinsic semiconductor layers I1 and I2, are formed along parts of the sidewall of the memory gate structure through the sidewall spacer. Thereby, the PIN junction structure is formed between the first select gate electrode G2a (G2b) and the second select gate electrode G3a (G3b). However, the present invention is not limited thereto. For example, in the electrode insulating portion formation step, the first select gate electrode G2a (G2b) and the second select gate electrode G3a (G3b) may be electrically insulated from each other by the select gate electrode insulating portions 13 and 14 (15 and 16) made of an intrinsic semiconductor layer and formed along part of the sidewall of the memory gate structure through the sidewall spacer. Thereby, a PIP junction structure or an NIN junction structure is formed between the first select gate electrode G2a (G2b) and the second select gate electrode G3a (G3b).

In another electrode insulating portion formation step, when the first select gate electrode G2a (G2b) and the second select gate electrode G3a (G3b) are of the N type, the select gate electrode insulating portions 13 and 14 (15 and 16) made of a P-type opposite-conductivity-type electrode insulating layer may be formed along parts of the sidewall of the memory gate structure through the sidewall spacer. Thereby, an NPN junction structure is formed between the first select gate electrode G2a (G2b) and the second select gate electrode G3a (G3b) and reverse bias is applied to the NPN junction structure. Thus, the first select gate electrode G2a (G2b) and the second select gate electrode G3a (G3b) are electrically insulated from each other.

In another electrode insulating portion formation step or when the first select gate electrode G2a (G2b) and the second select gate electrode G3a (G3b) are of the P type, the select gate electrode insulating portions 13 and 14 (15 and 16) made of an N-type opposite-conductivity-type electrode insulating layer may be formed along parts of the sidewall of the memory gate structure through the sidewall spacer. Thereby, a PNP junction structure is formed between the first select gate electrode G2a (G2b) and the second select gate electrode G3a (G3b) and reverse bias is applied to the PNP junction structure. Thus, the first select gate electrode G2a (G2b) and the second select gate electrode G3a (G3b) are electrically insulated from each other.

In the above-described embodiment, for example, the contact formation conductive layers 10a and 11a of the first column and the select gate electrode insulating portions 13 and 14 may be disposed at any positions as long as the first select gate electrode G2a continuous with the contact formation conductive layer 10a and the second select gate electrode G3a continuous with the contact formation conductive layer 11a are electrically insulated from each other and are separately controlled.

For example, in the memory circuit region ER1 of the semiconductor integrated circuit device 1 illustrated in FIG. 1, the single contact formation conductive layer 10a and the single select gate electrode insulating portion 13 are provided in the gate-contact insulating region ER12, and the single contact formation conductive layer 11a and the single select gate electrode insulating portion 14 are provided in the gate-contact insulating region ER13. However, the present invention is not limited thereto. The two contact formation conductive layers 10a and 11a may be provided in the gate-contact insulating region ER12, the single select gate electrode insulating portion 13 may be disposed between the two contact formation conductive layers 10a and 11a, and the single select gate electrode insulating portion 14 may be provided in the gate-contact insulating region ER13.

With this configuration, the first select gate electrode G2a continuous with the contact formation conductive layer 10a and the second select gate electrode G3a continuous with the contact formation conductive layer 11a are electrically insulated from each other to allow separate control of the first select gate electrode G2a and the second select gate electrode G3a.

In other words, in the method for producing a semiconductor integrated circuit device of the present invention, when the two or more contact formation conductive layers 10a, 11a, ... are provided, the select gate electrode insulating portions 13, 14, ... may be disposed at the positions to electrically insulate the select gate electrodes continuous with the respective contact formation conductive layers 10a, 11a, ... and so forth from each other.

In the above-described embodiment, the peripheral circuits 18 and 19 may be other various peripheral circuits (direct peripheral circuits) such as a sense amplifier, a column decoder, and a row decoder disposed in the same area as that of the memory cells 3a, 3b, 3c, 3d, 3e, and 3f. The peripheral circuits 18 and 19 may be other various peripheral circuits, such as a CPU, an ASIC, and an input and output circuit, which are disposed in an area different from that of the memory cells 3a, 3b, 3c, 3d, 3e, and 3f.

Reference Sings List

    1 semiconductor integrated circuit device
    3a, 3b, 3c, 3d, 3e, 3f memory cell
    4a, 4b memory gate structure
    5a, 5b first select gate structure
    6a, 6b second select gate structure
    13, 14, 15, 16 select gate electrode insulating portion
    G1a, G1b memory gate electrode
    G2a, G2b first select gate electrode
    G3a, G3b second select gate electrode
    EC charge storage layer
    23a lower gate insulating film

23b upper gate insulating film
I1, I2 intrinsic semiconductor layer
Rev opposite-conductivity-type electrode insulating layer
Rrla, Rrlb resist

**Claims**

1. A method for producing a semiconductor integrated circuit device (1) comprising a memory circuit region (ER1) and a peripheral circuit region (ER2), the memory circuit region including a memory cell (3a, 3b, 3c, 3d, 3e, 3f) in which a memory gate structure (4a, 4b) is disposed between a first select gate structure (5a, 5b) and a second select gate structure (6a, 6b) through a sidewall spacer (27a), the first select gate structure including a first select gate electrode (G2a, G2b), the second select gate structure including a second select gate electrode (G3a, G3b), the peripheral circuit region including a logic gate structure (7a, 7b) of a peripheral circuit (18, 19), the method comprising:

   a sidewall spacer formation step of forming the memory gate structure in the memory circuit region and then forming the sidewall spacer covering the memory gate structure, the memory gate structure including a lower gate insulating film (23a), a charge storage layer (EC), an upper gate insulating film (23b), and a memory gate electrode (G1a, G1b) stacked in this order;
   a conductive layer formation step of forming a gate insulating film (25a, 25b, 29a, 29b) in the memory circuit region in which the memory gate structure is formed and in the peripheral circuit region, and then forming an N-type or P-type conductive layer (37) on the gate insulating film;
   an electrode insulating portion formation step of forming, in the peripheral circuit region, an opposite-conductivity layer (38) of a conductivity type opposite to a conductivity type of the conductive layer, and forming, along a part of a sidewall of the memory gate electrode through the sidewall spacer, a select gate electrode insulating portion (13, 14, 15, 16) including at least an intrinsic semiconductor layer (I1 and I2) or an opposite-conductivity-type electrode insulating layer (Rev) of the conductivity type opposite to the conductivity type of the conductive layer; and
   a gate electrode formation step of etching back each of the conductive layer and the opposite-conductivity layer in the peripheral circuit region and the memory circuit region by using a resist (Rr1a, Rr1b) patterned by using a photomask, so as to allow the conductive layer and the opposite-conductivity layer to remain on the gate insulating film by using the resist and form a logic gate electrode (G5 and G6) of the logic gate structure in the peripheral circuit region, and to allow the sidewall-shaped first select gate electrode to remain along one sidewall of the memory gate electrode through the sidewall spacer and to allow the sidewall-shaped second select gate electrode to remain along the sidewall on another side of the memory gate electrode through the sidewall spacer in the memory circuit region,

   wherein the first select gate electrode and the second select gate electrode are electrically insulated from each other by the select gate electrode insulating portion, the select gate electrode insulating portion being disposed between the first select gate electrode and the second select gate electrode and **characterised by** forming a PIN junction structure, an NIN junction structure, a PIP junction structure, an NPN junction structure, or a PNP junction structure together with the first and second select gate electrodes.

2. The method for producing a semiconductor integrated circuit device according to claim 1, further comprising, before the sidewall spacer formation step, a first photomask processing step of implanting impurities by using a resist (Rm1) into a portion of the memory circuit region where the memory gate structure is to be formed, so as to form a channel formation layer on a substrate surface facing the memory gate structure, the resist being patterned by using a first photomask dedicated to fabrication of the memory circuit region,
   wherein the sidewall spacer formation step includes a second photomask processing step of forming a memory gate electrode conductive layer (35) on an entire surface of the upper gate insulating film and then patterning the memory gate electrode conductive layer by using a resist (Rm2), so as to form the memory gate electrode, the resist being patterned by using a second photomask dedicated to fabrication of the memory circuit region, and
   a dedicated photomask process using at least one photomask dedicated to formation of the memory cell in the memory circuit region includes a total of two steps, the two steps being the first photomask processing step and the second photomask processing step.

3. The method for producing a semiconductor integrated circuit device according to claim 2, wherein the sidewall spacer formation step includes, after the second photomask processing step, a third photomask processing step of implanting impurities by using a resist (Rm3) into portions of the memory circuit region where the first select gate electrode and the second select gate electrode are to be formed, so as to form the channel formation layer on the substrate surface facing the first select gate electrode and the second select gate electrode, the resist being patterned by using a third photomask dedicated to fabrication of the memory circuit region, and

the dedicated photomask process includes a total of three steps, the three steps being the first photomask processing step, the second photomask processing step, and the third photomask processing step.

4. The method for producing a semiconductor integrated circuit device according to any one of claims 1 to 3, wherein the first select gate electrode formed in the gate electrode formation step is connected to a first select gate line, the second select gate electrode formed in the gate electrode formation step is connected to a second select gate line different from the first select gate line, and the memory gate electrode is connected to a memory gate line.

5. A semiconductor integrated circuit device comprising:

a memory circuit region (ER1) including a memory cell (3a, 3b, 3c, 3d, 3e, 3f) in which a memory gate structure (4a, 4b) is disposed between a first select gate structure (5a, 5b) and a second select gate structure (6a, 6b) through a sidewall spacer (27a), the first select gate structure including a first select gate electrode (G2a, G2b), the second select gate structure including a second select gate electrode (G3a, G3b); and

a peripheral circuit region (ER2) including a logic gate structure (7a, 7b) of a peripheral circuit (18, 19), wherein the logic gate structure has a configuration in which a logic gate electrode (G5 and G6) is disposed on a gate insulating film (29a, 29b), the logic gate electrode being made of a n or p-type conductive layer (37) of a conductivity type same as a conductivity type of the first select gate electrode and the second select gate electrode or made of an opposite-conductivity layer (38) of a conductivity type opposite to a conductivity type of the conductive layer (37),

the memory gate structure has a configuration in which a lower gate insulating film (23a), a charge storage layer (EC), an upper gate insulating film (23b), and a memory gate electrode (G1a, G1b) are stacked in this order, and

the first select gate electrode and the second select gate electrode are sidewall-shaped along the sidewall spacer on a sidewall of the memory gate electrode, and are disposed along one line surrounding the memory gate electrode, and are electrically insulated from each other by a plurality of select gate electrode insulating portions each disposed between the first select gate electrode and the second select gate electrode, the select gate electrode insulating portions being **characterised by** forming a PIN junction structure, an NIN junction structure, a PIP junction structure, an NPN junction structure, or a PNP junction structure together with the first and second select gate electrodes.

**Patentansprüche**

1. Verfahren zur Herstellung einer integrierten Halbleitervorrichtung (1), die einen Speicherkreisbereich (ER1) und einen peripheren Schaltungsbereich (ER2) umfasst, wobei der Speicherkreisbereich eine Speicherzelle (3a, 3b, 3c, 3d, 3e, 3f) umfasst, bei der eine Speichergatterstruktur (4a, 4b) zwischen einer ersten Wahlgatterstruktur (5a, 5b) und einer zweiten Wahlgatterstruktur (6a, 6b) durch einen Seitenwandabstandhalter (27a) angeordnet ist, wobei die erste Wahlgatterstruktur eine erste Wahlgatterelektrode (G2a, G2b) umfasst, wobei die zweite Wahlgatterstruktur eine zweite Wahlgatterelektrode (G3a, G3b) umfasst, wobei der periphere Speicherbereich eine Logikgatterstruktur (7a, 7b) einer peripheren Schaltung (18, 19) umfasst, wobei das Verfahren umfasst:

einen Seitenwandabstandhalter-Bildungsschritt: Bilden der Speichergatterstruktur im Speicherkreisbereich, gefolgt durch Bilden des die Speichergatterstruktur abdeckenden Seitenwandabstandhalters, wobei die Speichergatterstruktur eine untere Gatterisolierfolie (23a), eine Ladungsspeicherschicht (EC), eine obere Gatterisolierfolie (23b) und eine Speichergatterelektrode (G1a, G1b) umfasst, die in der angegebenen Reihenfolge aufeinandergestapelt sind;

einen Leitungsschicht-Bildungsschritt: Bilden einer Gatterisolierfolie (25a, 25b, 29a, 29b) im Speicehrkreisbereich, in dem die Speichergatterstruktur ausgebildet ist, und im peripheren Schaltungsbereich, gefolgt durch: Bilden einer N- oder P-Leitungsschicht (37) auf der Gatterisolierfolie;

einen Elektrodenisolationsteil-Bildungsschritt: Bilden einer Schicht (38) mit einer einer Leitungsart der Leitungsschicht entgegengesetzten Leitungsart und Bilden eines mindestens eine Eigenhalbleiterschicht (I1 und I2) oder eine Elektrodenisolierschicht (Rev) der der Leitungsart der Leitungsschicht entgegengesetzten Leitungsart umfassenden Isolationsteils (13, 14, 15, 16) der Wahlgatterelektrode entlang eines Teils einer Seitenwand der Speichergatterelektrode durch den Seitenwandabstandhalter und

einen Gatterelektrodenbildungsschritt: Zurückätzen jeder der Leitungsschicht und der entgegengesetzten Leitungsschicht im peripheren Schaltungsbereich und im Speicherkreisbereich unter Verwendung eines mit einer Fotomaske strukturierten Widerstands (Rr1a, Rr1b), um es der Leitungsschicht und der entgegengesetzten Leitungsschicht zu ermöglichen, auf der Gatterisolierfolie unter Verwendung des Widerstands zu bleiben, und eine Logikgatterelektrode (G5 und G6) der Logikgatterstruktur im peripheren Schaltungsbereich zu bilden, und um es der seitenwandförmigen ersten Wahlgatterelektrode zu ermöglichen, entlang einer Seitenwand der Speichergatterelektrode durch den Seitenwandabstandhalter zu bleiben, und um es der seitenwandförmigen zweiten Wahlgatterelektrode zu ermöglichen, entlang der Seitenwand an einer anderen Seite der Speichergatterelektrode durch den Seitenwandabstandhalter im Speicherkreisbereich zu bleiben, wobei die erste Wahlgatterelektrode und die zweite Wahlgatterelektrode durch den Isolationsteil der Wahlgatterelektrode voneinander elektrisch isoliert sind, wobei der Isolationsteil der Wahlgatterelektrode zwischen der ersten Wahlgatterelektrode und der zweiten Wahlgatterelektrode angeordnet ist, und **dadurch gekennzeichnet sind, dass** sie zusammen mit den ersten und zweiten Wahlgatterelektroden eine PIN-, NIN-, PIP-, NPN- oder PNP-Übergangsstruktur bilden.

2.  Verfahren zur Herstellung einer integrierten Halbleitervorrichtung nach Anspruch 1, ferner umfassend, vor dem Bilden des Seitenwandabstandhalters: einen ersten Fotomaskenverarbeitungsschritt: Implantieren von Verunreinigungen in einen Teil des ersten Speicherkreisbereichs, in dem die Speichergatterstruktur zu bilden ist, unter Verwendung eines Widerstands (Rm1), um so eine Kanalbildungsschicht auf einer der Speichergatterstruktur zugewandten Substratoberfläche zu bilden, wobei der Widerstand mit einer für die Fertigung des Speicherkreisbereichs bestimmten ersten Fotomaske strukturiert ist,

    wobei das Bilden des Seitenwandabstandhalters einen zweiten Fotomaskenverarbeitungsschritt umfasst: Bilden einer Leitungsschicht (35) der Speichergatterelektrode auf einer ganzen Oberfläche der oberen Gatterisolierfolie, gefolgt durch Strukturieren der Leitungsschicht der Speichergatterelektrode unter Verwendung eines Widerstands (Rm2), um so die Speichergatterelektrode zu bilden, wobei der Widerstand mit einer für die Fertigung des Speicherkreisbereichs bestimmten zweiten Fotomaske strukturiert ist, und

    ein zweckbestimmter Fotomaskenprozess unter Verwendung mindestens einer für die Bildung der Speicherzelle im Speicherkreisbereich insgesamt zwei Schritte umfasst, wobei es sich bei den zwei Schritten um den ersten Fotomaskenverarbeitungsschritt und den zweiten Fotomaskenverarbeitungsschritt handelt.

3.  Verfahren zur Herstellung einer integrierten Halbleitervorrichtung nach Anspruch 2, wobei
    das Bilden des Seitenwandabstandhalters nach dem zweiten Fotomaskenverarbeitungsschritt einen dritten Fotomaskenverarbeitungsschritt umfasst:
    Implantieren von Verunreinigungen in Teile des Speicherkreisbereichs, in dem die erste Speichergatterelektrode und die zweite Speichergatterelektrode zu bilden sind, unter Verwendung eines Widerstands (Rm3), um so die Kanalbildungsschicht auf der der ersten Speichergatterelektrode und der zweiten Speichergatterelektrode zugewandten Substratoberfläche zu bilden, wobei der Widerstand mit einer für die Fertigung des Speicherkreisbereichs bestimmten dritten Fotomaske strukturiert ist, und
    der zweckbestimmte Fotomaskenprozess insgesamt drei Schritte umfasst, wobei es sich bei den drei Schritten um den ersten Fotomaskenverarbeitungsschritt, den zweiten Fotomaskenverarbeitungsschritt und den dritten Fotomaskenverarbeitungsschritt handelt.

4.  Verfahren zur Herstellung einer integrierten Halbleitervorrichtung nach einem der Ansprüche 1 - 3, wobei
    die im Gatterelektrodenbildungsschritt ausgebildete erste Wahlgatterelektrode an eine erste Wahlgatterleitung angeschlossen ist,
    die im Gatterelektrodenbildungsschritt ausgebildete zweite Wahlgatterelektrode an eine zweite Wahlgatterleitung angeschlossen ist, die sich von der ersten Wahlgatterleitung unterscheidet, und
    die Speichergatterelektrode an eine Speichergatterleitung angeschlossen ist.

5.  Integrierte Halbleitervorrichtung, umfassend:

    einen Speicherkreisbereich (ER1), umfassend eine Speicherzelle (3a, 3b, 3c, 3d, 3e, 3f), bei der eine Speichergatterstruktur (4a, 4b) zwischen einer ersten Wahlgatterstruktur (5a, 5b) und einer zweiten Wahlgatterstruktur (6a, 6b) durch einen Seitenwandabstandhalter (27a) angeordnet ist, wobei die erste Wahlgatterstruktur eine erste Wahlgatterelektrode (G2a, G2b) umfasst, wobei die zweite Wahlgatterstruktur eine zweite Wahlgatterelektrode (G3a, G3b) umfasst und

einen peripheren Speicherbereich (ER2), umfassend eine Logikgatterstruktur (7a, 7b) einer peripheren Schaltung (18, 19),

wobei die Logikgatterstruktur eine Konfiguration aufweist, in der eine Logikgatterelektrode (G5 und G6) auf einer Gatterisolierfolie (29a, 29b) angeordnet ist, wobei die Logikgatterelektrode aus einer n- oder p-Leitungsschicht (37) einer gleichen Leitungsart wie eine Leitungsart der ersten Wahlgatterelektrode und der zweiten Wahlgatterelektrode, oder aus einer Leitungsschicht (38), deren Leitungsart einer Leitungsart der Leitungsschicht (37) entgegengesetzt ist, besteht,

wobei die Speichergatterstruktur eine Konfiguration aufweist, in der eine untere Gatterisolierfolie (23a), eine Ladungsspeicherschicht (EC), eine obere Gatterisolierfolie (23b) und eine Speichergatterelektrode (G1a, G1b) in der angegebenen Reihenfolge aufeinandergestapelt sind; und

wobei die erste Wahlgatterelektrode und die zweite Wahlgatterelektrode entlang des Seitenwandabstandhalters an einer Seitenwand der Speichergatterelektrode seitenwandförmig und entlang einer die Speichergatterelektrode umgebenden Leitung angeordnet und durch eine Vielzahl Wahlgatterelektrodenisolationsteile voneinander elektrisch isoliert sind, die jeweils zwischen der ersten und der zweiten Wahlgatterelektrode angeordnet sind, wobei die Wahlgatterelektrodenisolationsteile **dadurch gekennzeichnet sind, dass** sie zusammen mit den ersten und zweiten Wahlgatterelektroden eine PIN-, NIN-, PIP-, NPN- oder PNP-Übergangsstruktur bilden.

## Revendications

1. Procédé de production d'un dispositif à circuits intégrés semi-conducteurs (1) comprenant une région de circuit de mémoire (ER1) et une région de circuit périphérique (ER2), la région de circuit de mémoire incluant une cellule de mémoire (3a, 3b, 3c, 3d, 3e, 3f) dans laquelle une structure de grille de mémoire (4a, 4b) est disposée entre une première structure de grille de sélection (5a, 5b) et une seconde structure de grille de sélection (6a, 6b) à travers une entretoise de paroi latérale (27a), la première structure de grille de sélection incluant une première électrode de grille de sélection (G2a, G2b), la seconde structure de grille de sélection incluant une seconde électrode de grille de sélection (G3a, G3b), la région de circuit périphérique incluant une structure de grille logique (7a, 7b) d'un circuit périphérique (18, 19), le procédé comprenant :

   une étape de formation d'entretoise de paroi latérale consistant à former la structure de grille de mémoire dans la région de circuit de mémoire et puis à former l'entretoise de paroi latérale recouvrant la structure de grille de mémoire, la structure de grille de mémoire incluant un film isolant de grille inférieur (23a), une couche de stockage de charge (EC), un film isolant de grille supérieur (23b) et une électrode de grille de mémoire (G1a, G1b) empilés dans cet ordre ;

   une étape de formation de couche conductrice consistant à former un film isolant de grille (25a, 25b, 29a, 29b) dans la région de circuit de mémoire dans laquelle la structure de grille de mémoire est formée dans la région de circuit périphérique, et puis à former une couche conductrice de type N ou de type P (37) sur le film isolant de grille ;

   une étape de formation de partie isolante d'électrode consistant à former, dans la région de circuit périphérique, une couche de conductivité opposée (38) d'un type de conductivité opposé à un type de conductivité de la couche conductrice, et à former, le long d'une partie d'une paroi latérale de l'électrode de grille de mémoire à travers l'entretoise de paroi latérale, une partie isolante d'électrode de grille de sélection (13, 14, 15, 16) incluant au moins une couche semi-conductrice intrinsèque (I1 et I2) ou une couche isolante d'électrode de type de conductivité opposé (Rev) du type de conductivité opposé au type de conductivité de la couche conductrice ; et

   une étape de formation d'électrode de grille consistant à graver en retrait chacune de la couche conductrice et de la couche de conductivité opposée dans la région de circuit périphérique et la région de circuit de mémoire au moyen d'une réserve (Rr1a, Rr1b) modelée en utilisant un masque photographique, de sorte à permettre à la couche conductrice et à la couche de conductivité opposée de rester sur le film isolant de grille au moyen de la réserve et à former une électrode de grille logique (G5 et G6) de la structure de grille logique dans la région de circuit périphérique, et à permettre à la première électrode de grille de sélection façonnée sur la paroi latérale de rester le long d'une paroi latérale de l'électrode de grille de mémoire à travers l'entretoise de paroi latérale et à permettre à la seconde électrode de grille de sélection façonnée sur la paroi latérale de rester le long de la paroi latérale sur un autre côté de l'électrode de grille de mémoire à travers l'entretoise de paroi latérale dans la région de circuit de mémoire,

   dans lequel la première électrode de grille de sélection et la seconde électrode de grille de sélection sont isolées électriquement l'une de l'autre par la partie isolante d'électrode de grille de sélection, la partie isolante d'électrode de grille de sélection étant disposée entre la première électrode de grille de sélection et la seconde électrode de grille de sélection et **caractérisé par** la formation d'une structure de jonction PIN, d'une structure de jonction NIN, d'une structure de jonction PIP, d'une structure de jonction NPN ou d'une structure de jonction PNP conjointement avec les première et seconde électrodes de grille de sélection.

2. Procédé de production d'un dispositif à circuits intégrés semi-conducteurs selon la revendication 1, comprenant en outre, avant l'étape de formation d'entretoise de paroi latérale, une première étape de traitement au masque photographique consistant à implanter des impuretés en utilisant une réserve (Rm1) dans une partie de la région de circuit de mémoire où la structure de grille de mémoire doit être formée, de sorte à former une couche de formation de canal sur une surface de substrat faisant face à la structure de grille de mémoire, la réserve étant modelée en utilisant un premier masque photographique dédié à la fabrication de la région de circuit de mémoire, dans lequel l'étape de formation d'entretoise de paroi latérale inclut une seconde étape de traitement au masque photographique consistant à former une couche conductrice d'électrode de grille de mémoire (35) sur une surface entière du film isolant de grille supérieur et puis à modeler la couche conductrice d'électrode de grille de mémoire en utilisant une réserve (Rm2), de sorte à former l'électrode de grille de mémoire, la réserve étant modelée en utilisant un second masque photographique dédié à la fabrication de la région de circuit de mémoire, et un traitement au masque photographique dédié utilisant au moins un masque photographique dédié à la formation de la cellule de mémoire dans la région de circuit de mémoire inclut un total de deux étapes, les deux étapes étant la première étape de traitement au masque photographique et la seconde étape de traitement au masque photographique.

3. Procédé de production d'un dispositif à circuits intégrés semi-conducteurs selon la revendication 2, dans lequel l'étape de formation d'entretoise de paroi latérale inclut, après la seconde étape de traitement au masque photographique, une troisième étape de traitement au masque photographique consistant à implanter des impuretés au moyen d'une réserve (Rm3) dans des parties de la région de circuit de mémoire où la première électrode de grille de sélection et la seconde électrode de grille de sélection doivent être formées, de sorte à former la couche de formation de canal sur la surface de substrat faisant face à la première électrode de grille de sélection et à la seconde électrode de grille de sélection, la réserve étant modelée au moyen d'un troisième masque photographique dédié à la fabrication de la région de circuit de mémoire, et le traitement au masque photographique dédié inclut un total de trois étapes, les trois étapes étant la première étape de traitement au masque photographique, la deuxième étape de traitement au masque photographique et la troisième étape de traitement au masque photographique.

4. Procédé de production d'un dispositif à circuits intégrés semi-conducteurs selon l'une quelconque des revendications 1 à 3, dans lequel la première électrode de grille de sélection formée dans l'étape de formation d'électrode de grille est connectée à une première ligne de grille de sélection, la seconde électrode de grille de sélection formée dans l'étape de formation de grille est connectée à une seconde ligne de grille de sélection différente de la première ligne de grille de sélection, et l'électrode de grille de mémoire est connectée à une ligne de grille de mémoire.

5. Dispositif à circuits intégrés semi-conducteurs comprenant :

une région de circuit de mémoire (ER1) incluant une cellule de mémoire (3a, 3b, 3c, 3d, 3e, 3f) dans laquelle une structure de grille de mémoire (4a, 4b) est disposée entre une première structure de grille de sélection (5a, 5b) et une seconde structure de grille de sélection (6a, 6b) à travers une entretoise de paroi latérale (27a), la première structure de grille de sélection incluant une première électrode de grille de sélection (G2a, G2b), la seconde structure de grille de sélection incluant une seconde électrode de grille de sélection (G3a, G3b) ; et une région de circuit périphérique (ER2) incluant une structure de grille logique (7a, 7b) d'un circuit périphérique (18, 19), dans lequel la structure de grille logique a une configuration dans laquelle une électrode de grille logique (G5 et G6) est disposée sur un film isolant de grille (29a, 29b), l'électrode de grille logique étant constituée d'une couche conductrice de type n ou de type p (37) d'un même type de conductivité qu'un type de conductivité de la première électrode de grille de sélection et de la seconde électrode de grille de sélection ou constituée d'une couche de conductivité opposée (38) d'un type de conductivité opposé à un type de conductivité de la couche conductrice (37), la structure de grille de mémoire a une configuration dans laquelle un film isolant de grille inférieur (23a), une couche de stockage de charge (EC), un film isolant de grille supérieur (23b) et une électrode de grille de mémoire (G1a, G1b) sont empilés dans cet ordre, et

la première électrode de grille de sélection et la seconde électrode de grille de sélection sont façonnées sur la paroi latérale le long de l'entretoise de paroi latérale sur une paroi latérale de l'électrode de grille de mémoire, et sont disposées le long d'une ligne entourant l'électrode de grille de mémoire, et sont isolées électriquement l'une de l'autre par une pluralité de parties isolantes d'électrode de grille de sélection disposées chacune entre la première électrode de grille de sélection et la seconde électrode de grille de sélection, les parties isolantes d'électrode de grille de sélection étant **caractérisées par** la formation d'une structure de jonction PIN, d'une structure de jonction NIN, d'une structure de jonction PIP, d'une structure de jonction NPN ou d'une structure de jonction PNP conjointement avec les première et seconde électrodes de grille de sélection.

FIG. 1

FIG. 2

EP 3 208 831 B1

FIG. 3

FIG. 4

MEMORY CIRCUIT REGION PERIPHERAL CIRCUIT REGION

ER1 30a ER2

S

20 W2 20 W3

FIG. 5A

Rm1

30a

S

W1 20 W2 20 W3

FIG. 5B

EC 23b 35 30b 30a

S

23a W1 20 W2 20 W3

FIG. 5C

FIG. 6A

FIG. 6B

FIG. 6C

FIG. 7A

FIG. 7B

FIG. 7C

EP 3 208 831 B1

ER1                                    ER2

FIG. 8A

FIG. 8B

FIG. 9

FIG. 10A

FIG. 10B

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011129816 A

- US 2010165736 A1